(19) Europäisches Patentamt / European Patent Office / Office européen des brevets

(11) **EP 4 657 680 A1**

(12) **EUROPEAN PATENT APPLICATION**
published in accordance with Art. 153(4) EPC

(43) Date of publication:
**03.12.2025 Bulletin 2025/49**

(21) Application number: **24755822.4**

(22) Date of filing: **03.01.2024**

(51) International Patent Classification (IPC):
**H01S 5/0687** (2006.01)

(52) Cooperative Patent Classification (CPC):
**H01S 3/00; H01S 3/10; H01S 5/0687**

(86) International application number:
**PCT/CN2024/070323**

(87) International publication number:
**WO 2024/169446 (22.08.2024 Gazette 2024/34)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **17.02.2023 CN 202310176246**

(71) Applicant: **Huawei Technologies Co., Ltd.**
**Shenzhen, Guangdong 518129 (CN)**

(72) Inventors:
• **CHEN, Xi**
  **Shenzhen, Guangdong 518129 (CN)**
• **CHEN, Zifeng**
  **Wuhan, Hubei 430074 (CN)**
• **GUO, Weihua**
  **Wuhan, Hubei 430074 (CN)**

(74) Representative: **Körber, Martin Hans**
**Mitscherlich PartmbB**
**Patent- und Rechtsanwälte**
**Karlstraße 7**
**80333 München (DE)**

(54) **FREQUENCY DIFFERENCE ADJUSTER, FREQUENCY DIFFERENCE ADJUSTMENT METHOD, LASER GENERATING APPARATUS, AND ELECTRONIC DEVICE**

(57) Embodiments of this application provide a frequency difference adjuster (10C), a frequency difference adjustment method, a laser generation apparatus (100), and an electronic device (1000). A tunable comb filter (1C) is reused to filter a first optical signal and a second optical signal, to obtain a first filtered optical signal and a second filtered optical signal. Optical-to-electrical conversion is performed on the first filtered optical signal and the second filtered optical signal, to obtain a first filtered electrical signal and a second filtered electrical signal. A frequency of the first optical signal and a frequency of the second optical signal are obtained respectively based on the first filtered electrical signal and the second filtered electrical signal. Then, a first laser (A) is controlled to adjust the frequency of the output first optical signal, so that a frequency difference between the first optical signal and the second optical signal remains at a first frequency difference. In embodiments of this application, the tunable comb filter (1C) is used, and an adjusted frequency difference range is larger. In addition, in a scenario in which the tunable comb filter (1C) is reused, the frequency difference between the first optical signal and the second optical signal relative to the tunable comb filter (1C) remains stable, and there is no need to perform temperature calibration on a start frequency of the tunable comb filter (1C).

FIG. 6

**Description**

This application claims priority to Chinese Patent Application No. 202310176246.3, filed with the China National Intellectual Property Administration on February 17, 2023 and entitled "FREQUENCY DIFFERENCE ADJUSTER, FREQUENCY DIFFERENCE ADJUSTMENT METHOD, LASER GENERATION APPARATUS, AND ELECTRONIC DEVICE", which is incorporated herein by reference in its entirety.

**TECHNICAL FIELD**

This application relates to the field of optical signal application technologies, and in particular, to a frequency difference adjuster, a frequency difference adjustment method, a laser generation apparatus, and an electronic device.

**BACKGROUND**

In some applications of optical signals, a frequency of a first optical signal needs to be controlled based on a frequency of a second optical signal. For example, a frequency difference between the first optical signal and the second optical signal is controlled to remain relatively fixed (for example, the frequency difference between the first optical signal and the second optical signal always remains at a first frequency difference). During actual application, a first laser and a second laser need to be used to generate corresponding optical signals. To ensure that the frequency difference between the first optical signal and the second optical signal remains relatively fixed, the first laser needs to be adjusted.

A frequency difference adjustment manner is as follows: Two polarization controllers are used to ensure that polarization states of the first optical signal and the second optical signal that are output by the first laser and the second laser are aligned. Then, a photodetector converts the input first optical signal and the input second optical signal into electrical signals, obtains a frequency difference signal, and adjusts the first laser based on the frequency difference signal. However, frequency difference detection in this manner is limited by a bandwidth of the photodetector, and consequently, this manner is difficult to apply to frequency difference detection in a larger frequency difference range.

**SUMMARY**

Embodiments of this application provide a frequency difference adjuster, a frequency difference adjustment method, a laser generation apparatus, and an electronic device, to implement frequency difference detection in a larger frequency difference range.

To achieve the foregoing objective, the following technical solutions are adopted in embodiments of this application.

According to a first aspect, a frequency difference adjuster is provided. The frequency difference adjuster includes a tunable comb filter, a first optical detection unit, and a control unit. The tunable comb filter is coupled to the first optical detection unit, and the first optical detection unit is coupled to the control unit. The tunable comb filter is configured to output a first filtered optical signal to the first optical detection unit based on a first optical signal, and output a second filtered optical signal to the first optical detection unit based on a second optical signal, where the first optical signal is an optical signal output by a first laser. The first optical detection unit is configured to output a first filtered electrical signal based on the first filtered optical signal, and output a second filtered electrical signal based on the second filtered optical signal, where the first filtered electrical signal indicates an optical power of the first filtered optical signal, and the second filtered electrical signal indicates an optical power of the second filtered optical signal. The control unit is configured to output a frequency difference control signal to the first laser based on the first filtered electrical signal and the second filtered electrical signal, where the frequency difference control signal is used to control the first laser to adjust a frequency difference between the first optical signal and the second optical signal to a first frequency difference.

In this embodiment of this application, the first optical signal and the second optical signal are input to the tunable comb filter, to respectively obtain the first filtered optical signal and the second filtered optical signal. The first optical detection unit separately performs optical-to-electrical conversion on the first filtered optical signal and the second filtered optical signal, to obtain the first filtered electrical signal and the second filtered electrical signal. Relative frequencies of the first optical signal and the second optical signal within one FSR of the tunable comb filter are respectively obtained based on the first filtered electrical signal and the second filtered electrical signal, to obtain a relative frequency difference between the first optical signal and the second optical signal within the FSR. In some application scenarios, a quantity of FSRs (that is, a quantity of interval periods) between the first optical signal and the second optical signal on the tunable comb filter is known, or may be directly obtained. In this case, an absolute frequency difference between the first optical signal and the second optical signal may be learned of based on a relative frequency difference within one FSR and a quantity of FSR periods that are obtained through calculation. The control unit adjusts the first laser based on the absolute frequency difference, to adjust a frequency of the first optical signal, so that the frequency difference between the first optical signal and the second optical signal remains at the first frequency difference. However, in some other application scenarios, the frequency difference between the first optical signal and the second optical signal can be adjusted without determining a quantity of FSR periods between the first optical signal and the second optical signal.

In a possible implementation, the frequency difference adjuster further includes a second optical detection unit. The second optical detection unit is coupled to the control unit. The second optical detection unit is configured to output a first electrical signal based on the first optical signal, and output a second electrical signal based on the second optical signal, where the first electrical signal indicates an optical power of the first optical signal, and the second electrical signal indicates an optical power of the second optical signal. The control unit is further configured to output a frequency adjustment signal to the tunable comb filter based on the first electrical signal and the first filtered electrical signal, where the frequency adjustment signal is used to adjust a frequency of the tunable comb filter.

For example, the second optical signal is used as an example. Theoretically, a corresponding frequency-power response relationship is definite after the second optical signal is input into the tunable comb filter. Therefore, regardless of a frequency with any magnitude, there is a definite optical power value. However, a corresponding signal frequency may be better determined when an optical power has some special values, for example, when a value of the optical power is a maximum value, a minimum value, or a median value. In this case, the first optical signal and the second optical signal may be input through the second optical detection unit. In addition, the first electrical signal is obtained based on the first optical signal, and the second electrical signal is obtained based on the second optical signal. The control unit may determine a first optical power ratio between the first optical signal and the first filtered optical signal based on the first electrical signal and the second filtered electrical signal, and determine a position of the second optical signal on a frequency-power response curve of the tunable comb filter based on the first optical power ratio. Similarly, a second signal processor in the control unit may determine a second optical power ratio between the second optical signal and the second filtered optical signal based on the second electrical signal and the second filtered electrical signal, and determine a position of the second optical signal on the frequency-power response curve of the tunable comb filter based on the second optical power ratio.

In this embodiment of this application, the frequency adjustment signal is used to control some frequencies of one FSR frequency period of the tunable comb filter to be aligned with a frequency of the second optical signal and/or the frequency of the first optical signal, so that precision of adjusting the first frequency difference can be improved.

In a possible implementation, the frequency difference adjuster further includes a selector and a first splitter. The selector is coupled to the first splitter and the control unit, and the first splitter is coupled to the tunable comb filter and the second optical detection unit. The selector is configured to input the first optical signal and the second optical signal. The control unit is further configured to control the selector to output the first optical signal or the second optical signal to the tunable comb filter and the second optical detection unit through the first splitter.

For example, when outputting the first optical signal, the selector outputs the input first optical signal to the tunable comb filter and the second optical detection unit through the first splitter. The tunable comb filter filters the input first optical signal to obtain the first filtered optical signal, and outputs the first filtered optical signal to the first optical detection unit. The first optical detection unit converts the input first filtered optical signal into the first filtered electrical signal, and outputs the first filtered electrical signal to the control unit. In this case, the second optical detection unit converts the input first optical signal into the first electrical signal, and outputs the first electrical signal to the control unit. The control unit obtains a ratio between the optical power of the first optical signal and the optical power of the first filtered optical signal based on the input first electrical signal and the input first filtered electrical signal, to determine a frequency value of the first optical signal in one FSR frequency period of the tunable comb filter.

For example, when outputting the second optical signal, the selector outputs the input second optical signal to the tunable comb filter and the second optical detection unit through the first splitter. The tunable comb filter filters the input second optical signal to obtain the second filtered optical signal, and outputs the second filtered optical signal to the first optical detection unit. The first optical detection unit converts the input second filtered optical signal into the second filtered electrical signal, and outputs the second filtered electrical signal to the control unit. In this case, the second optical detection unit converts the input second optical signal into the second electrical signal, and outputs the second electrical signal to the control unit. The control unit obtains a ratio between the optical power of the second optical signal and the optical power of the second filtered optical signal based on the input second electrical signal and the input second filtered electrical signal, to determine a frequency value of the second optical signal in one FSR frequency period of the tunable comb filter.

In this embodiment of this application, the selector is controlled to output the first optical signal or the second optical signal, so that the first optical signal and the second optical signal are separately input to the tunable comb filter and the second optical detection unit, to reuse the tunable comb filter and the second optical detection unit. In this case, both the first optical signal and the second optical signal are filtered and output by the tunable comb filter. In this case, a quantity of frequency difference adjusters is decreased, and there is no need to calibrate the frequency-power response relationship for the tunable comb filter based on different temperatures.

In a possible implementation, the frequency difference adjuster further includes a first splitter, a first demultiplexer, and a second demultiplexer, the first optical detection unit includes a first primary photodetector and a first secondary photodetector, and the second optical detection unit includes a second primary photodetector and a second secondary photodetector. An output end of the first splitter is coupled to an input end of the tunable comb filter and an input end of the second demultiplexer, and the first splitter is configured to input the first optical signal and the second optical signal. An output end of the tunable comb filter is coupled to an input end of the first demultiplexer. An output end of the first demultiplexer is coupled to an input end of the first primary photodetector and an input end of the first secondary photodetector. An output end of the second demultiplexer is coupled to an input end of the second primary photodetector and an input end of the second secondary photodetector. An output end of the first primary photodetector, an output end of the first secondary photodetector, an output end of the second primary photodetector, and an output end of the second secondary photodetector are coupled to the control unit.

For example, the first splitter is configured to input the first optical signal and the second optical signal, and output a mixed optical signal to the tunable comb filter and the second demultiplexer, where the mixed optical signal includes the first optical signal and the second optical signal. The tunable comb filter is configured to output a mixed filtered optical signal to the first demultiplexer based on the mixed optical signal, where the mixed filtered optical signal includes the first filtered optical signal and the second filtered optical signal. The first demultiplexer is configured to output the first filtered optical signal to the first secondary photodetector, and output the second filtered optical signal to the first primary photodetector. The second demultiplexer is configured to output the first optical signal to the second secondary photodetector, and output the second optical signal to the second primary photodetector. The first secondary photodetector is configured to output the first filtered electrical signal to the control unit based on the first filtered optical signal. The first primary photodetector is configured to output the second filtered electrical signal to the control unit based on the second filtered optical signal. The second secondary photodetector is configured to output the first electrical signal to the control unit based on the first optical signal. The second primary photodetector is configured to output the second electrical signal to the control unit based on the second optical signal.

In this embodiment of this application, the mixed optical signal including the first optical signal and the second optical signal is input to the tunable comb filter, and the first demultiplexer demultiplexes the first filtered optical signal and the second filtered optical signal. The first filtered optical signal is input to the first secondary photodetector, optical-to-electrical conversion is performed to obtain the first filtered electrical signal, and the first filtered electrical signal is output to the control unit. The second filtered optical signal is input to the first primary photodetector, optical-to-electrical conversion is performed to obtain the second filtered electrical signal, and the second filtered electrical signal is output to the control unit. After the mixed optical signal is input to the second demultiplexer, the second demultiplexer outputs the first optical signal to the second secondary photodetector, and outputs the second optical signal to the second primary photodetector. The second secondary photodetector performs optical-to-electrical conversion on the first optical signal, and outputs the first electrical signal to the control unit. The second primary photodetector performs optical-to-electrical conversion on the second optical signal, and outputs the second electrical signal to the control unit. The control unit determines a ratio between the optical power of the first optical signal and the optical power of the first filtered optical signal based on the first electrical signal and the first filtered electrical signal, to determine a frequency value of the first optical signal in one FSR frequency period of the tunable comb filter. The control unit determines a ratio between the optical power of the second optical signal and the optical power of the second filtered optical signal based on the second electrical signal and the second filtered electrical signal, to determine a frequency value of the second optical signal in one FSR frequency period of the tunable comb filter. In this embodiment of this application, the demultiplexers are used to perform demultiplexing, so that the tunable comb filter can simultaneously input the first optical signal and the second optical signal for processing. Compared with the solution in which the selector is controlled to separately input the first optical signal and the second optical signal to the tunable comb filter, in this solution, a control procedure is shortened, and a speed of controlling adjustment of the frequency of the first optical signal is accelerated.

In a possible implementation, the frequency difference adjuster further includes a combiner, a second splitter, a third splitter, and a first demultiplexer, the first optical detection unit includes a first primary photodetector and a first secondary photodetector, and the second optical detection unit includes a second primary photodetector and a second secondary photodetector. An output end of the second splitter is coupled to an input end of the combiner and an input end of the second primary photodetector, and the second splitter is configured to input the second optical signal. An output end of the third splitter is coupled to the input end of the combiner and an input end of the second secondary photodetector, and the third splitter is configured to input the first optical signal. An output end of the combiner is coupled to an input end of the tunable comb filter, and an output end of the tunable comb filter is coupled to an input end of the first demultiplexer. An output end of the first demultiplexer is coupled to an input end of the first primary photodetector and an input end of the first secondary photodetector. An output end of the first primary photodetector, an output end of the first secondary photodetector, an output end of the second primary photodetector, and an output end of the second secondary photodetector are coupled to the control unit.

For example, the second splitter is configured to input the second optical signal, and output the second optical signal to the combiner and the second primary photodetector. The third splitter is configured to input the first optical signal, and output the first optical signal to the combiner and the second secondary photodetector. The combiner is configured to output a mixed optical signal to the tunable comb filter, where the mixed optical signal includes the first optical signal and the second optical signal. The tunable comb filter is configured to output a mixed filtered optical signal to the first demultiplexer based on the mixed optical signal, where the mixed filtered optical signal includes the first filtered optical signal and the second filtered optical signal. The first demultiplexer is configured to output the first filtered optical signal to the first secondary photodetector, and output the second filtered optical signal to the first primary photodetector. The first secondary photodetector is configured to output the first filtered electrical signal to the control unit based on the first filtered optical signal. The first primary photodetector is configured to output the second filtered electrical signal to the control unit based on the second filtered optical signal. The second secondary photodetector is configured to output the first electrical signal to the control unit based on the first optical signal. The second primary photodetector is configured to output the second electrical signal to the control unit based on the second optical signal.

In this embodiment of this application, the second splitter inputs the second optical signal and splits the second optical signal into two signals, where one signal is output to the combiner, and the other signal is output to the second primary photodetector. The second splitter inputs the first optical signal and splits the first optical signal into two signals, where one signal is output to the combiner, and the other signal is output to the second secondary photodetector. After the first optical signal and the second optical signal are input to the combiner, the combiner outputs the mixed optical signal to the tunable comb filter. Compared with the foregoing solution based on the first splitter, in this solution based on the second splitter and the third splitter in this embodiment of this application, one demultiplexer is reduced, and a quantity of splitters is increased. In addition, compared with the solution in the foregoing embodiment in which the selector is used, in this solution in which the second splitter and the third splitter are used in this embodiment of this application, a control procedure is also shortened, and a speed of controlling adjustment of the first optical signal output by the first laser is accelerated.

In a possible implementation, the tunable comb filter is a complementary tunable comb filter.

For example, the tunable comb filter is configured to output the first filtered optical signal to the first optical detection unit based on the first optical signal, and output the second filtered optical signal to the first optical detection unit based on the second optical signal; and output a first complementary filtered optical signal to the second optical detection unit based on the first optical signal, and output a second complementary filtered optical signal to the second optical detection unit based on the second optical signal, where a frequency-power response relationship for the first filtered optical signal and a frequency-power response relationship for the first complementary filtered optical signal are reversed, and a frequency-power response relationship for the second filtered optical signal and a frequency-power response relationship for the second complementary filtered optical signal are reversed.

The first optical detection unit is configured to output the first filtered electrical signal based on the first filtered optical signal, and output the second filtered electrical signal based on the second filtered optical signal, where the first filtered electrical signal indicates the optical power of the first filtered optical signal, and the second filtered electrical signal indicates the optical power of the second filtered optical signal. The second optical detection unit is configured to output a first complementary filtered electrical signal based on the first complementary filtered optical signal, and output a second complementary filtered electrical signal based on the second complementary filtered optical signal, where the first complementary filtered electrical signal indicates an optical power of the first complementary filtered optical signal, and the second complementary filtered electrical signal indicates an optical power of the second complementary filtered optical signal.

The control unit is specifically configured to output a frequency adjustment signal to the tunable comb filter based on the second complementary filtered electrical signal and the second filtered electrical signal, where the frequency adjustment signal is used to adjust a frequency of the tunable comb filter; output a first frequency control signal to the first laser based on the first filtered electrical signal and the first complementary filtered electrical signal; output a second frequency control signal to a second laser based on the second filtered electrical signal and the second complementary filtered electrical signal; and output the frequency difference control signal to the first laser based on the first filtered electrical signal, the second filtered electrical signal, the first complementary filtered electrical signal, and the second complementary filtered electrical signal.

In this embodiment of this application, when the tunable comb filter is a complementary tunable comb filter, for one optical signal, one filtered optical signal and one complementary filtered optical signal may be obtained, and frequency-power response relationships for the two optical signals are reversed. A change rate of an optical power difference between the filtered optical signal and the complementary filtered optical signal is greater than a change rate of an optical power difference between the filtered optical signal and the optical signal input to the tunable comb filter. Therefore, compared with a non-complementary tunable comb filter, the complementary tunable comb filter can be used to more easily adjust a frequency value of the first optical signal and a frequency value of the second optical signal in one FSR frequency period of the tunable comb filter.

In some possible implementations, the frequency difference adjuster further includes a second optical detection unit, and the tunable comb filter is further coupled to the control unit through a second photodetector. The tunable comb filter is further configured to output a first complementary filtered optical signal to the second optical detection unit based on the first optical signal, and output a second complementary filtered optical signal to the second optical detection unit based on the second optical signal, where a frequency-power response relationship for the first filtered optical signal and a frequency-power response relationship for the first complementary filtered optical signal are reversed, and a frequency-power response relationship for the second filtered optical signal and a frequency-power response relationship for the second complementary filtered optical signal are reversed. The second optical detection unit is configured to output a first complementary filtered electrical signal based on the first complementary filtered optical signal, and output a second complementary filtered electrical signal based on the second complementary filtered optical signal, where the first complementary filtered electrical signal indicates an optical power of the first complementary filtered optical signal, and the second complementary filtered electrical signal indicates an optical power of the second complementary filtered optical signal. The control unit is specifically configured to output a frequency adjustment signal to the tunable comb filter based on the second complementary filtered electrical signal and the second filtered electrical signal, where the frequency adjustment signal is used to adjust a frequency of the tunable comb filter; and output the frequency difference control signal to the first laser based on the first filtered electrical signal, the second filtered electrical signal, the first complementary filtered electrical signal, and the second complementary filtered electrical signal.

In a possible implementation, the frequency difference adjuster further includes a selector, and the selector is coupled to the tunable comb filter. The selector is configured to input the first optical signal and the second optical signal. The control unit is further configured to control the selector to output the first optical signal or the second optical signal to the tunable comb filter.

For example, there may be a plurality of first lasers. The control unit controls the selector to input, to the tunable comb filter, a first optical signal output by one of the plurality of first lasers, or the control unit controls the selector to input, to the tunable comb filter, a second optical signal output by a second laser.

In this embodiment of this application, the frequency difference adjuster may be reused through the selector, and a frequency of the second optical signal is used as a reference to adjust frequencies of first optical signals output by the plurality of first lasers. Adjusted frequencies of the plurality of first optical signals may be the same or different.

In this embodiment of this application, the selector controls to input the first optical signal or the second optical signal to the tunable comb filter, so that one frequency difference adjuster is reused. For an application principle and a technical effect of the selector in this embodiment of this application, refer to the descriptions of the selector in the foregoing embodiment. Details are not described herein again.

In a possible implementation, the frequency difference adjuster includes a combiner, a first demultiplexer, and a second demultiplexer, the first optical detection unit includes a first primary photodetector and a first secondary photodetector, and the second optical detection unit includes a second primary photodetector and a second secondary photodetector. An output end of the combiner is coupled to an input end of the tunable comb filter, and the combiner is configured to input the first optical signal and the second optical signal. An output end of the tunable comb filter is coupled to an input end of the first demultiplexer and an input end of the second demultiplexer. An output end of the first demultiplexer is coupled to an input end of the first primary photodetector and an input end of the first secondary photodetector. An output end of the second demultiplexer is coupled to an input end of the second primary photodetector and an input end of the second secondary photodetector. An output end of the first primary photodetector, an output end of the first secondary photodetector, an output end of the second primary photodetector, and an output end of the second secondary photodetector are coupled to the control unit.

For example, the combiner is configured to input the first optical signal and the second optical signal, and output a mixed optical signal to the tunable comb filter, where the mixed optical signal includes the first optical signal and the second optical signal. The tunable comb filter is configured to output a mixed filtered optical signal to the first demultiplexer based on the mixed optical signal, and output a mixed complementary filtered optical signal to the second demultiplexer, where the mixed filtered optical signal includes the first filtered optical signal and the second filtered optical signal, and the mixed complementary filtered optical signal includes a first complementary filtered optical signal and a second complementary filtered optical signal. The first demultiplexer is configured to output the first filtered optical signal to the first secondary photodetector, and output the second filtered optical signal to the first primary photodetector. The second demultiplexer is configured to output the first complementary filtered optical signal to the second secondary photodetector, and output the second complementary filtered optical signal to the second primary photodetector. The first secondary photodetector is configured to output the first filtered electrical signal to the control unit based on the first filtered optical signal. The first primary photodetector is configured to output the second filtered electrical signal to the control unit based on the second filtered optical signal. The second secondary photodetector is configured to output a first complementary filtered electrical signal to the control unit based on the first complementary filtered optical signal. The second primary photodetector is configured to output a second complementary filtered electrical signal to the control unit based on the second complementary filtered optical signal.

In this embodiment of this application, based on power differences indicated by the complementary filtered electrical signals and the filtered electrical signals, a frequency value can be more easily determined, and one FSR frequency period of the tunable comb filter can be adjusted to be aligned with the frequencies of the second optical signal and the first optical signal. In addition, the combiner outputs the mixed optical signal to the tunable comb filter. Compared with controlling the first optical signal or the second optical signal through the selector, this reduces a control procedure, and accelerates a speed of controlling adjustment of the frequency difference between the first optical signal and the second optical signal to the first frequency difference.

In some possible implementations, the relative frequency difference between the first optical signal and the second optical signal needs to be adjusted only relative to one FSR frequency period of the tunable comb filter.

For example, a formula for calculating the relative frequency difference between the first optical signal and the second optical signal is as follows:

$$\mathrm{dx} = \begin{cases} f1\text{-}f2, Fs > Fm \\ f1\text{-}f2, Fs < Fm \end{cases}$$

In the formula, dx represents the relative frequency difference between the first optical signal and the second optical signal, $f1$ represents a difference between a frequency value of the first optical signal in one FSR frequency period and a start frequency value of the FSR frequency period, $f2$ represents a difference between a frequency value of the second optical signal in one FSR frequency period and a start frequency value of the FSR frequency period, $Fs$ represents a frequency value of the first optical signal, and $Fm$ represents a frequency value of the second optical signal.

In some possible implementations, a quantity N of FSR frequency periods between the first optical signal and the second optical signal is known, and the absolute frequency difference between the first optical signal and the second optical signal may be directly adjusted based on the quantity N of FSR frequency periods.

For example, a formula for calculating the absolute frequency difference between the first optical signal and the second optical signal is as follows:

$$\mathrm{df} = Fs\text{--}Fm = \begin{cases} N * FSR\text{--}(f1\text{--}f2), Fs > Fm \\ -N * FSR\text{--}(f1\text{--}f2), Fs < Fm \end{cases}$$

In the formula, df represents the absolute frequency difference between the first optical signal and the second optical signal, $f1$ represents a difference between a frequency value of the first optical signal in one FSR frequency period and a start frequency value of the FSR frequency period, $f2$ represents a difference between a frequency value of the second optical signal in one FSR frequency period and a start frequency value of the FSR frequency period, $Fs$ represents a frequency value of the first optical signal, $Fm$ represents a frequency value of the second optical signal, and N represents the quantity of FSR frequency periods between the first optical signal and the second optical signal.

In a possible implementation, the second optical signal is an optical signal output by a second laser, and the frequency difference adjuster further includes a first period detector, a second period detector, a first reference laser, and a second reference laser. The first reference laser is configured to output a first reference optical signal to the first period detector, and the second reference laser is configured to output a second reference optical signal to the second period detector, where a frequency period interval between the first reference optical signal and the second reference optical signal is fixed. The first period detector is configured to output a first interval signal to the control unit based on the first optical signal and the first reference optical signal, where the first interval signal indicates a frequency period interval between the first optical signal and the first reference optical signal. The second period detector is configured to output a second interval signal to the control unit based on the second optical signal and the second reference optical signal, where the second interval signal indicates a frequency period interval between the second optical signal and the second reference optical signal. The control unit is configured to output a first frequency control signal to the first laser based on the first interval signal, where the first frequency control signal is used to control the first laser to adjust a frequency of the first optical signal; or output a first frequency control signal to the first reference laser based on the first interval signal, where the first frequency control signal is used to control the first reference laser to adjust a frequency of the first reference optical signal; and output a second frequency control signal to the second laser based on the second interval signal, where the second frequency control signal is used to control the second laser to adjust a frequency of the second optical signal.

For example, when the quantity of FSR periods between the first optical signal and the second optical signal is uncertain, and in a current application scenario, the absolute frequency difference between the first optical signal and the second optical signal needs to be determined based on the quantity of FSR periods between the first optical signal and the second optical signal, the first reference laser and the second reference laser may be disposed to generate the first reference optical signal and the second reference optical signal respectively. The first reference optical signal and the second reference optical signal are optical signals with fixed frequencies, and a quantity of FSR periods between the first reference optical signal and the second reference optical signal is fixed. The first period detector and the second period detector are frequency difference detection components that can be used to determine, within a specific range, whether a frequency between input optical signals is within a specific frequency period interval. The first optical signal and the first reference optical signal are input to the first period detector, and the first period detector outputs the first interval signal to the control unit based on the first optical signal and the first reference optical signal, where the first interval signal indicates a quantity of interval frequency periods between the first optical signal and the first reference optical signal. The control unit outputs the first frequency control signal to the first laser or the first reference laser based on the first interval signal, so that a quantity of FSR periods between the first optical signal and the first reference optical signal is fixed by using the first frequency control signal, for example, the quantity of FSR periods between the first optical signal and the first reference optical signal is 0 (that is, the first optical signal and the first reference optical signal are in a same FSR period) or another fixed value. Similarly, the control unit may obtain the second interval signal based on the second optical signal and the second reference optical signal, and output the second frequency control signal to the second laser based on the second interval signal. The second frequency control signal is used to control the second laser to adjust the frequency of the output second optical signal, so that a quantity of FSR frequency periods between the second optical signal and the second reference optical signal is fixed. For example, the quantity of FSR frequency periods between the second optical signal and the second reference optical signal is 0 or another fixed value. Because a quantity of FSR periods between the first reference optical signal and the second reference optical signal before adjustment is fixed, and a changed quantity of FSR periods during adjustment can be learned of, the quantity of FSR periods between the first optical signal and the second optical signal may be determined based on the changed quantity of FSR periods and the quantity of interval FSR periods before adjustment.

For example, a formula for calculating a quantity of FSR frequency periods between the first reference optical signal and the second reference optical signal is set as follows:

$$N = Nr \pm N1 \pm N2$$

In the formula, N represents the quantity of FSR frequency periods between the first optical signal and the second optical signal, Nr represents the quantity of FSR frequency periods between the first reference optical signal and the second reference optical signal, N1 represents the quantity of FSR frequency periods between the first optical signal and the first reference optical signal, and N2 represents the quantity of FSR frequency periods between the second optical signal and the second reference optical signal.

In this embodiment of this application, the first frequency control signal output by the control unit may be used to adjust the frequency of the first optical signal output by the first laser or the frequency of the first reference optical signal output by the first reference laser may be adjusted, to adjust a value of N1. The second frequency control signal output by the control unit may be used to adjust the frequency of the second reference optical signal output by the second reference laser, to adjust a value of N2. An objective of this application is to adjust the frequency of the first optical signal to maintain a specific frequency difference between the frequency of the first optical signal and the frequency of the second optical signal. Therefore, for precision of the frequency difference, the frequency of the second optical signal output by the second laser is generally not adjusted.

In a possible implementation, the control unit includes a signal processor and a controller. The signal processor is configured to output a frequency difference signal to the controller based on the first filtered electrical signal and the second filtered electrical signal, where the frequency difference signal indicates the frequency difference between the first optical signal and the second optical signal. The controller is configured to output the frequency difference control signal to the first laser based on the frequency difference signal.

In this embodiment of this application, the second signal processor may determine a power of the first optical signal and a power of the second optical signal based on the first filtered electrical signal and the second filtered electrical signal, and determine the relative frequency difference between the first optical signal and the second optical signal based on the power of the first optical signal and the power of the second optical signal. Then, the second signal processor outputs the frequency difference signal to the controller. The controller outputs a responding frequency difference control signal based on the frequency difference signal, and controls, based on the frequency difference control signal, the first laser to adjust the frequency of the first optical signal, so that the frequency difference between the first optical signal and the second optical signal remains at the first frequency difference.

In some possible implementations, the tunable comb filter may be a sinusoidal tunable comb filter, a sawtooth tunable comb filter, or the like. Regardless of a type of the tunable comb filter, a function described in this embodiment of this application can be implemented.

In some possible implementations, a material of the tunable comb filter may be, for example, silicon, silicon dioxide, lithium niobate, an III-V material (for example, indium phosphide), or a polymer.

In some possible implementations, a structure of the tunable comb filter may be a planar reflection type, a Mach-Zehnder interference type, or the like.

In some possible implementations, the tunable comb filter may be a thermally tunable comb filter, an electrically tunable comb filter, or the like.

In some possible implementations, the frequency difference adjuster may be disposed as an independent component. A pluggable control interface is usually disposed on the first laser. The frequency difference adjuster receives the first optical signal and the second optical signal, and outputs the frequency difference control signal to the first laser through the control interface on the first laser, to adjust the frequency difference between the first optical signal and the second optical signal to the first frequency difference.

According to a second aspect, an embodiment of this application provides a frequency difference adjustment method, applied to a frequency difference adjuster. The frequency difference adjuster includes a tunable comb filter. The method includes: obtaining a first filtered optical signal based on a first optical signal, and obtaining a second filtered optical signal based on a second optical signal, where the first optical signal is an optical signal output by a first laser; obtaining a first filtered electrical signal based on the first filtered optical signal, and obtaining a second filtered electrical signal based on the second filtered optical signal, where the first filtered electrical signal indicates an optical power of the first filtered optical signal, and the second filtered electrical signal indicates an optical power of the second filtered optical signal; and outputting a frequency difference control signal to the first laser based on the first filtered electrical signal and the second filtered electrical signal, where the frequency difference control signal is used to control the first laser to adjust a frequency difference between the first optical signal and the second optical signal to a first frequency difference.

In this embodiment of this application, one tunable comb filter is reused to filter the first optical signal and the second optical signal, to obtain the first filtered optical signal and the second filtered optical signal. Optical-to-electrical conversion is performed on the first filtered optical signal and the second filtered optical signal to obtain the first filtered electrical signal and the second filtered electrical signal. The frequency value of the first optical signal is obtained based on the first filtered electrical signal. The frequency value of the second optical signal is obtained based on the second filtered electrical signal. Then, the frequency difference control signal is used to control the first laser A to adjust the frequency of the output first optical signal, so that the frequency difference between the first optical signal and the second optical signal remains at the first frequency difference. Compared with a solution in which a polarization controller and a photodetector are used to implement frequency difference adjustment, in this embodiment of this application, the tunable comb filter is used, and a frequency difference range that can be detected and adjusted is larger. In addition, an FSR period of the comb filter is fixed and is hardly affected by a temperature. However, a start frequency of the comb filter is susceptible to the temperature. Therefore, in a scenario in which two comb filters are used, impact of the temperature on the two comb filters needs to be calibrated respectively, to obtain a frequency-power response relationship corresponding to an absolute frequency. However, in a scenario in which a tunable comb filter is reused, the frequency difference between the first optical signal and the second optical signal relative to the tunable comb filter remains stable, and there is no need to perform temperature calibration on a start frequency of the tunable comb filter, that is, there is no need to adjust the frequency difference between the first optical signal and the second optical signal.

In a possible implementation, the method further includes: obtaining a first electrical signal based on the first optical signal, and obtaining a second electrical signal based on the second optical signal, where the first electrical signal indicates an optical power of the first optical signal, and the second electrical signal indicates an optical power of the second optical signal; and outputting a frequency adjustment signal to the tunable comb filter based on the first electrical signal and the first filtered electrical signal, where the frequency adjustment signal is used to adjust a frequency of the tunable comb filter.

In a possible implementation, the method further includes: controlling the first optical signal or the second optical signal to be input to the tunable comb filter.

In a possible implementation, the tunable comb filter is a complementary tunable comb filter. The method further includes: obtaining a first complementary filtered optical signal based on the first optical signal, and obtaining a second complementary filtered optical signal based on the second optical signal, where a frequency-power response relationship for the first filtered optical signal and a frequency-power response relationship for the first complementary filtered optical signal are reversed, and a frequency-power response relationship for the second filtered optical signal and a frequency-power response relationship for the second complementary filtered optical signal are reversed; obtaining a first complementary filtered electrical signal based on the first complementary filtered optical signal, and obtaining a second complementary filtered electrical signal based on the second complementary filtered optical signal, where the first complementary filtered electrical signal indicates an optical power of the first complementary filtered optical signal, and the second complementary filtered electrical signal indicates an optical power of the second complementary filtered optical signal; outputting a frequency adjustment signal to the tunable comb filter based on the second complementary filtered electrical signal and the second filtered electrical signal, where the frequency adjustment signal is used to adjust a frequency of the tunable comb filter; and outputting the frequency difference control signal to the first laser based on the first filtered electrical signal, the second filtered electrical signal, the first complementary filtered electrical signal, and the second complementary filtered electrical signal.

In a possible implementation, the method further includes: controlling the first optical signal or the second optical signal to be input to the tunable comb filter.

In a possible implementation, the second optical signal is an optical signal output by a second laser. The method further includes: obtaining a first interval signal based on the first optical signal and a first reference optical signal, and obtaining a second interval signal based on the second optical signal and a second reference optical signal, where a frequency period interval between the first reference optical signal and the second reference optical signal is fixed, the first interval signal indicates a frequency period interval between the first optical signal and the first reference optical signal, and the second interval signal indicates a frequency period interval between the second optical signal and the second reference optical signal; outputting a first frequency control signal to the first laser based on the first interval signal, where the first frequency control signal is used to control the first laser to adjust a frequency of the first optical signal; or outputting a first frequency control signal to a first reference laser based on the first interval signal, where the first frequency control signal is used to control the first reference laser to adjust a frequency of the first reference optical signal; and outputting a second frequency control signal to the second laser based on the second interval signal, where the second frequency control signal is used to control the second laser to adjust a frequency of the second optical signal.

In a possible implementation, outputting the frequency difference control signal to the first laser based on the first filtered electrical signal and the second filtered electrical signal includes: obtaining a frequency difference signal based on the first filtered electrical signal and the second filtered electrical signal, where the frequency difference signal indicates the frequency difference between the first optical signal and the second optical signal; and outputting the frequency difference control signal to the first laser based on the frequency difference signal.

According to a third aspect, an embodiment of this application further provides a laser generation apparatus, including a first laser and the frequency difference adjuster described in the first aspect.

In this embodiment of this application, the laser generation apparatus includes the first laser and the frequency difference adjuster. In this case, the laser generation apparatus may be considered as a laser component that can perform automatic alignment. The laser generation apparatus receives a second optical signal, and calibrates a frequency of an output first optical signal based on the second optical signal.

For example, the laser generation apparatus further includes a second laser.

In this embodiment of this application, the laser generation apparatus includes the first laser, the second laser, and the frequency difference adjuster. In this case, the laser generation apparatus 100 is a laser component that can output a plurality of optical signals with a fixed frequency difference.

According to a fourth aspect, an embodiment of this application further provides an electronic device. The electronic device includes a circuit board and the laser generation apparatus described in the third aspect.

For example, the electronic device may be a laser output device, an inspection equipment, a gas detection device, a communication device, a calibration device (like a wavelength meter), or the like.

For example, in some communication application scenarios, one or more pairs of optical signals with a fixed frequency difference need to be used to generate radio frequency signals of different frequency bands in a manner like coherent beat frequency modulation. In this case, it needs to be ensured that a frequency difference between a plurality of optical signals output by a laser that provides an optical signal used for beat frequency is fixed in real time (where frequencies of the optical signals may change, but the frequency difference between the optical signals is fixed). In this case, the frequency difference between the plurality of optical signals may be dynamically adjusted through the frequency difference adjuster and the laser generation apparatus that are described in the foregoing embodiments.

According to a fifth aspect, an embodiment of this application further provides a chip system. The chip system includes at least one controller and at least one interface circuit. The at least one controller and the at least one interface circuit may be interconnected through a line. The controller is configured to support the chip system in implementing functions or steps in the foregoing method embodiments, for example, performing the method described in the second aspect. The at least one interface circuit may be configured to receive a signal from another apparatus (for example, a laser or a memory), or send a signal to another apparatus (for example, a laser or a communication interface). The chip system may include a chip, and may further include another discrete component.

According to a sixth aspect, an embodiment of this application further provides a computer-readable storage medium. The computer-readable storage medium includes instructions. When the instructions are run on the frequency difference adjuster described in the first aspect, the frequency difference adjuster is enabled to perform the method described in the second aspect. When the instructions are run on the laser generation apparatus described in the third aspect, the laser generation apparatus is enabled to perform the method described in the second aspect. When the instructions are run on the electronic device described in the fourth aspect, the electronic device is enabled to perform the method described in the second aspect.

For technical principles and technical effects of the second aspect, the third aspect, the fourth aspect, the fifth aspect, and the sixth aspect, refer to related descriptions of the first aspect. Details are not described again.

**BRIEF DESCRIPTION OF DRAWINGS**

FIG. 1 is a diagram of a structure of an electronic device according to an embodiment of this application;

FIG. 2 is a diagram of a structure of a laser generation apparatus according to an embodiment of this application;

FIG. 3 is a diagram of a structure of another laser generation apparatus according to an embodiment of this application;

FIG. 4 is a diagram of a structure of a frequency difference adjuster according to an embodiment of this application;

FIG. 5 is a diagram of a structure of another frequency difference adjuster according to an embodiment of this application;

FIG. 6 is a diagram of a structure of another frequency difference adjuster according to an embodiment of this application;

FIG. 7 is a diagram of a structure of another frequency difference adjuster according to an embodiment of this application;

FIG. 8 is a diagram of a structure of another frequency difference adjuster according to an embodiment of this application;

FIG. 9 is a diagram of a structure of another frequency difference adjuster according to an embodiment of this application;

FIG. 10 is a diagram of a structure of another frequency difference adjuster according to an embodiment of this application;

FIG. 11 is a diagram of a structure of another frequency difference adjuster according to an embodiment of this application;

FIG. 12 is a diagram of a structure of another frequency difference adjuster according to an embodiment of this application;

FIG. 13 is a diagram of a structure of another frequency difference adjuster according to an embodiment of this application;

FIG. 14 is a diagram of a structure of another frequency difference adjuster according to an embodiment of this application;

FIG. 15 is a diagram of a structure of another frequency difference adjuster according to an embodiment of this application;

FIG. 16 is a diagram of a structure of another frequency difference adjuster according to an embodiment of this application;

FIG. 17 is a diagram of a structure of another frequency difference adjuster according to an embodiment of this application;

FIG. 18 is a diagram of a structure of another frequency difference adjuster according to an embodiment of this application;

FIG. 19 is a schematic flowchart of a frequency difference adjustment method according to an embodiment of this application;

FIG. 20 is a schematic flowchart of another frequency difference adjustment method according to an embodiment of this application;

FIG. 21 is a schematic flowchart of another frequency difference adjustment method according to an embodiment of this application;

FIG. 22 is a diagram of a power-frequency response curve and a free spectral range frequency period of a tunable comb filter according to an embodiment of this application;

FIG. 23 is another diagram of a power-frequency response curve, a free spectral range frequency period, and a special frequency of a tunable comb filter according to an embodiment of this application;

FIG. 24 is another diagram of a power-frequency response curve, a free spectral range frequency period, and a special frequency of a tunable comb filter according to an embodiment of this application;

FIG. 25 is another diagram of a power-frequency response curve and a special frequency of a tunable comb filter according to an embodiment of this application;

FIG. 26 is another diagram of a power-frequency response curve of a tunable comb filter and calculation of a frequency difference between a first optical signal and a second optical signal based on a quantity of FSR frequency periods according to an embodiment of this application;

FIG. 27 is another diagram of a power-frequency response curve of a tunable comb filter and calculation of a quantity of FSR frequency periods;

FIG. 28 is a schematic flowchart of a control procedure in which a selector performs frequency adjustment on a plurality of first optical signals based on a second optical signal according to an embodiment of this application; and

FIG. 29 is a diagram of a structure of a chip system according to an embodiment of this application.

## DESCRIPTION OF EMBODIMENTS

It should be noted that the terms such as "first" and "second" in embodiments of this application are merely used to distinguish between features of a same type, and cannot be understood as an indication of relative importance, a quantity, a sequence, or the like.

The term such as "example" or "for example" in embodiments of this application is used to represent giving an example, an illustration, or a description. Any embodiment or design scheme described as an "example" or "for example" in this application should not be explained as being more preferred or having more advantages than another embodiment or design scheme. Exactly, use of the term such as "example" or "for example" is intended to present a related concept in a specific manner.

The terms "coupling" and "connection" in embodiments of this application should be understood in a broad sense. For example, the terms may be a physical direct connection, or may be an indirect connection implemented through an electronic component, for example, a connection implemented through a resistor, an inductor, a capacitor, or another electronic component.

First, some basic concepts in embodiments of this application are described.

During communication, a data signal whose transmission needs to be performed is modulated onto an optical signal, and transmission of the optical signal that carries the data signal is performed over an optical fiber; or a radio frequency signal is generated based on an optical signal, and a data signal is carried by the radio frequency signal, to implement wireless communication. In some application scenarios, a frequency difference between a first optical signal and a second optical signal needs to remain relatively fixed (for example, the frequency difference between the first optical signal and the second optical signal always remains at a first frequency difference). During actual application, a first laser and a second laser need to be used to generate corresponding optical signals. To ensure that the frequency difference between the first optical signal and the second optical signal remains relatively fixed, the first laser needs to be adjusted.

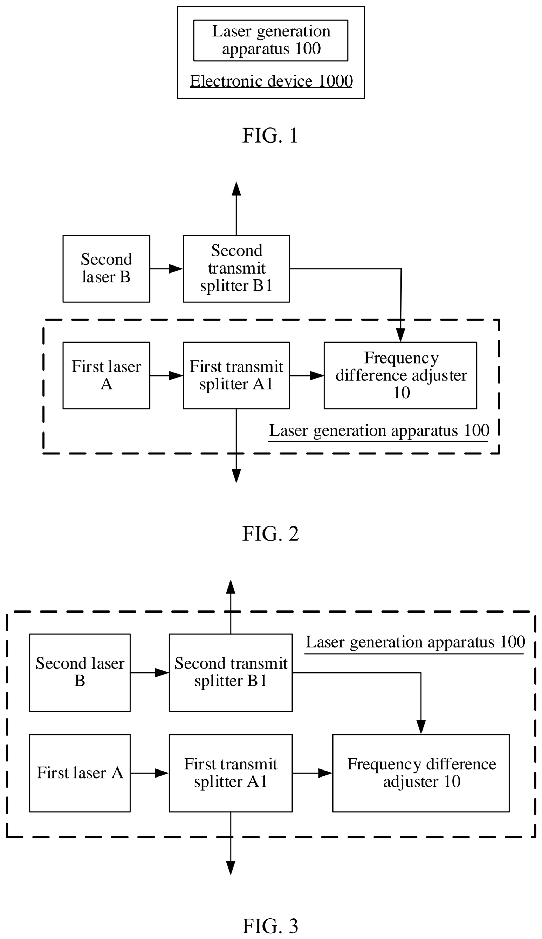

An embodiment of this application provides an electronic device. As shown in FIG. 1, the electronic device 1000 includes a laser generation apparatus 100. As shown in FIG. 2, the laser generation apparatus 100 includes a frequency difference adjuster 10 and a first laser A. The frequency difference adjuster 10 in the laser generation apparatus 100 is further coupled to a second laser B. As shown in FIG. 3, the laser generation apparatus 100 includes the frequency difference adjuster 10, the first laser A, and the second laser B. The first laser A is configured to output a first optical signal. The second laser B is configured to output a second optical signal. The frequency difference adjuster 10 is configured to obtain a frequency difference between the first optical signal and the second optical signal, and adjust, based on the frequency difference, a frequency of the first optical signal output by the first laser A.

In this embodiment of this application, in some application scenarios, the frequency difference between the first optical signal output by the first laser A and the second optical signal output by the second laser B needs to remain relatively fixed, for example, remain at a first frequency difference. In this case, the frequency difference adjuster 10 needs to detect the frequency difference between the first optical signal and the second optical signal, and adjust the frequency of the first optical signal, so that the frequency difference between the first optical signal and the second optical signal always remains at the first frequency difference.

For example, as shown in FIG. 2 and FIG. 3, when the laser generation apparatus 100 further includes the first laser A, a first transmit splitter A1 may be further disposed at an output end of the first laser A. As shown in FIG. 3, when the laser generation apparatus 100 further includes the second laser B, a second transmit splitter B1 may be further disposed at an output end of the second laser B.

In this embodiment of this application, a function of the first transmit splitter A1 is to split the first optical signal output by the first laser A into two or more signals, where one signal is input to the frequency difference adjuster 10 for frequency difference detection, and the other signal or signals may be transmitted to another setting or apparatus. A function of the second transmit splitter B1 is to split the second optical signal output by the second laser B into two or more signals, where one signal is input to the frequency difference adjuster 10 for frequency difference detection, and the other signal or signals may be transmitted to another setting or apparatus.

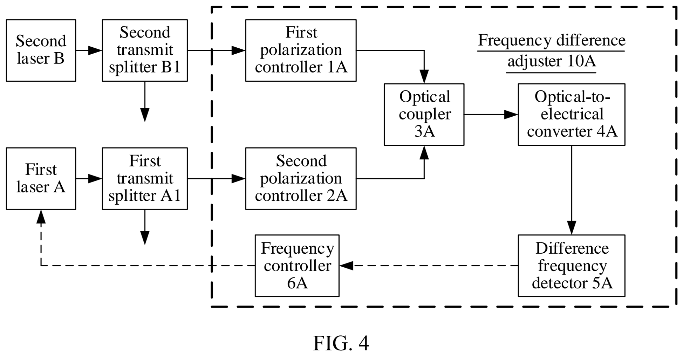

An embodiment of this application provides a frequency difference adjuster 10A. As shown in FIG. 4, the frequency difference adjuster 10A includes a first polarization controller 1A, a second polarization controller 2A, an optical coupler 3A, an optical-to-electrical converter 4A, a difference frequency detector 5A, and a frequency controller 6A. The first polarization controller 1A is coupled to a first laser A and the optical coupler 3A, and the second polarization controller 2A is coupled to a second laser B and the optical coupler 3A. The optical coupler 3A is coupled to the optical-to-electrical converter 4A. The optical-to-electrical converter 4A is coupled to the difference frequency detector 5A. The difference frequency detector 5A is coupled to the frequency controller 6A. The frequency controller 6A is coupled to the first laser A.

For example, as shown in FIG. 4, the first polarization controller 1A and the second polarization controller 2A perform polarization state alignment respectively on a first optical signal and a second optical signal. Then, the input first optical signal and the input second optical signal are converted into electrical signals through the optical-to-electrical converter 4A, and a frequency difference signal is obtained through the difference frequency detector 5A. The frequency controller 6A adjusts the first laser A based on the frequency difference signal, so that a frequency difference between the first optical signal and the second optical signal remains at a first frequency difference. The optical-to-electrical converter 4A is usually a photodetector. However, frequency difference detection in this manner is limited by a bandwidth of the photodetector, and consequently, this manner is difficult to apply to frequency difference detection in a larger frequency difference range.

For example, the optical-to-electrical converter 4A is a photodetector (photodetector). After the first optical signal and the second optical signal are input to the photodetector, a beat frequency (beat frequency, BF) phenomenon occurs. The beat frequency means that if oscillation frequencies (or referred to as frequencies for short) of two signals that undergo simple harmonic oscillation (simple harmonic oscillation, SHO) are close, and a difference between the frequencies of the two signals is far less than respective frequencies, after the signals are superimposed, there is a beat frequency in terms of time. The two signals that undergo simple harmonic oscillation are used as an example. The two signals are represented as $x_1(t)=\cos(t)$ and $x_2(t)=\sin(1.2t)$. After the two signals are superimposed, it can be found that oscillation of a signal obtained through combination is not simple harmonic oscillation. In this case, an oscillation frequency of the combined signal is close to the oscillation frequency of $x_1(t)$ and the oscillation frequency of $x_2(t)$, but an amplitude of the combined signal changes in another large period. When two signals with a small frequency difference that undergo simple harmonic oscillation are combined, a phenomenon in which an amplitude of a combined signal changes unstably and periodically is referred to as a beat (beat). A frequency at which the beat occurs is referred to as a beat frequency. A beat frequency principle of the photodetector is as follows: After receiving two optical signals with different frequencies, the photodetector performs frequency mixing on the optical signals, and perform conversion to obtain electrical signals. If frequencies of the first optical signal and the second optical signal that are received by the photodetector are $f_1$ and $f_2$ respectively, when the photodetector performs frequency mixing, a frequency-mixed electrical signal whose frequency is $f_1+f_2$ and a frequency-mixed electrical signal whose frequency is $f_1-f_2$ are obtained. Generally, the frequencies $f_1$ and $f_2$ are high, and the bandwidth of the photodetector is less than $f_1+f_2$. In this case, the photodetector is equivalent to a low-pass filter, and filters out a signal whose frequency is $f_1+f_2$, only a signal whose frequency is $f_1-f_2$ is left, and the electrical signal whose frequency is $f_1-f_2$ may be used as an electrical signal obtained through beat frequency.

In the implementation shown in FIG. 4, an electrical signal whose frequency is $f_1-f_2$ and that is obtained through the optical-to-electrical converter 4A also has a requirement on a difference between the frequency $f_1$ of the first optical signal and the frequency $f_2$ of the second optical signal. Limited by a bandwidth of the optical-to-electrical converter 5A, when the frequency difference between the first optical signal and the second optical signal is excessively large, it is also difficult for the optical-to-electrical converter 5A to perform conversion. In addition, the first polarization controller 1A and the second polarization controller 2A further need to be disposed to perform polarization state alignment on the first optical signal and the second optical signal, and in this case, use of the component is also complex.

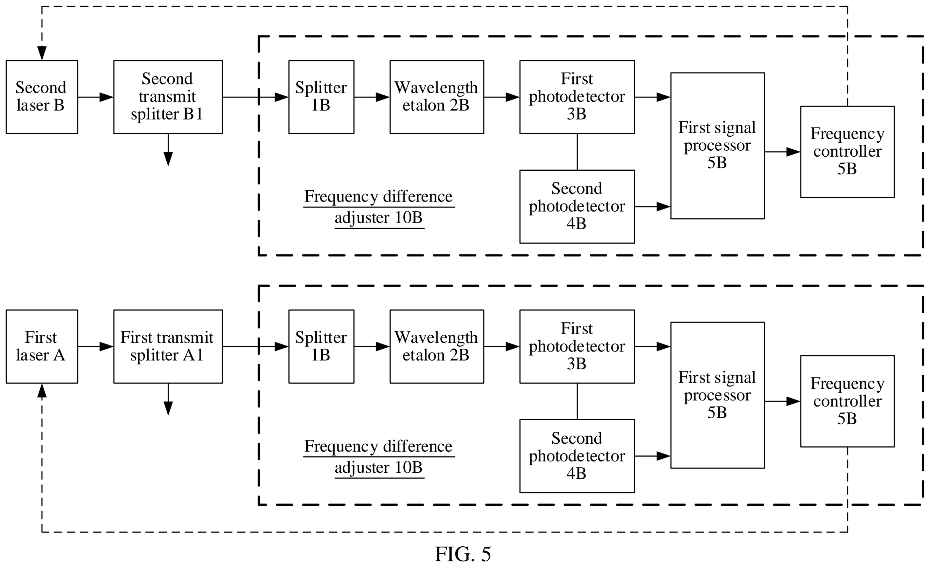

Based on this, an embodiment of this application further provides a frequency difference adjuster 10B. As shown in FIG. 5, two frequency difference adjusters 10B are disposed, and the two frequency difference adjusters 10B are respectively coupled to a first laser A and a second laser B. One frequency difference adjuster 10B includes a splitter 1B, a wavelength etalon (etalon) 2B, a first photodetector 3B, a second photodetector 4B, a first signal processor 5B, and a frequency controller 6B. The wavelength etalon (etalon) 2B is a fabry-perot wavelength etalon (fabry-perot etalon, FPE).

The splitter 1B is configured to input one optical signal, split the input optical signal into two optical signals, and output the two optical signals to the wavelength etalon 2B and the second photodetector 4B respectively. The wavelength etalon 2B is configured to filter the input optical signal, and then output a filtered optical signal to the first photodetector 3B. The first photodetector 3B is configured to obtain a filtered electrical signal based on the input filtered optical signal, where the filtered electrical signal indicates an optical power of the filtered optical signal. The second photodetector 4B is configured to obtain an electrical signal based on the input optical signal, where the electrical signal indicates an optical power of the input optical signal. The first signal processor 5B is configured to obtain a frequency signal based on the two electrical signals output by the first photodetector 3B and the second photodetector 4B, where the frequency signal indicates a frequency value of an input optical signal. The frequency controller 6B is configured to control, based on the frequency signal, a frequency value of a first optical signal output by the first laser A, or a frequency value of a second optical signal output by the second laser B.

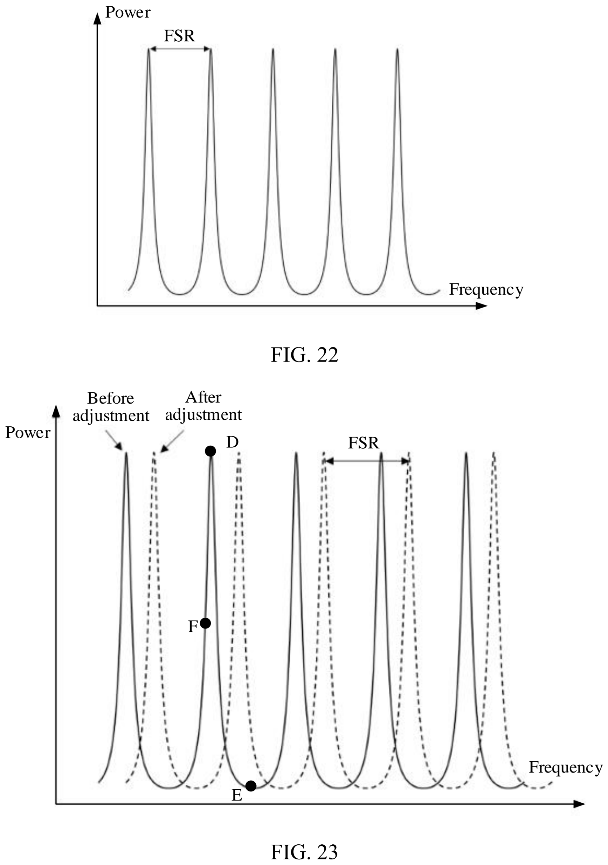

In this embodiment of this application, the wavelength etalon 2B is essentially a calibrated comb filter. As shown in FIG. 22, the wavelength etalon 2B has periodic power responses corresponding to optical signals with different frequency values. A frequency period of the comb filter for a power response may be referred to as a free spectral range (free spectral range, FSR). The frequency difference adjuster 10B coupled to the first laser A is used as an example. The first signal processor 5B may determine a ratio between an optical power of a first filtered optical signal and an optical power of the first optical signal based on the two input electrical signals, and may determine a relative frequency value of the first optical signal in one FSR range based on the ratio between the optical power of the first filtered optical signal and the optical power of the first optical signal. Then, the first signal processor 5B may determine an absolute frequency value of the first optical signal based on a calibrated FSR sequence number of the wavelength etalon 2B. Similarly, the frequency difference adjuster 10B coupled to the second laser B may also determine an absolute frequency value of the second optical signal. The two frequency difference adjusters 10B respectively adjust the first laser A and the second laser B based on the corresponding absolute frequency values, so that a frequency difference between the first optical signal and the second optical signal remains at a first frequency difference. However, in the implementation shown in FIG. 5, two frequency difference adjusters 10B are needed. In addition, because FSR sequence numbers of wavelength etalons 2B need to be obtained to confirm the absolute frequency value of the first optical signal and the absolute frequency value of the second optical signal, absolute frequency calibration for different temperatures needs to be performed in advance on the two wavelength etalons 2B.

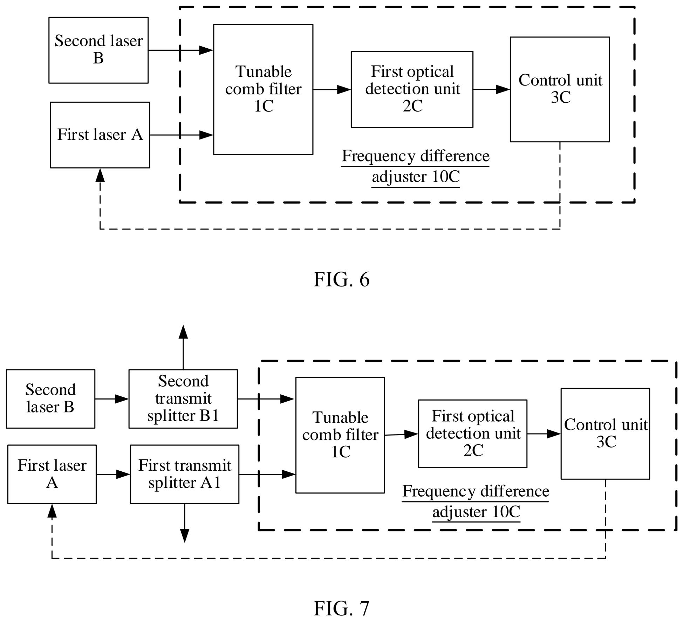

Based on this, an embodiment of this application further provides a frequency difference adjuster 10C. As shown in FIG. 6, the frequency difference adjuster 10C includes a tunable comb filter 1C, a first optical detection unit 2C, and a control unit 3C. The tunable comb filter 1C is coupled to the first optical detection unit 2C, and the first optical detection unit 2C is coupled to the control unit 3C.

The tunable comb filter 1C is configured to output a first filtered optical signal to the first optical detection unit 2C based on a first optical signal, and output a second filtered optical signal to the first optical detection unit 2C based on a second optical signal, where the first optical signal is an optical signal output by a first laser A, and the second optical signal is an optical signal output by a second laser B.

The first optical detection unit 2C is configured to output a first filtered electrical signal based on the first filtered optical signal, and output a second filtered electrical signal based on the second filtered optical signal, where the first filtered electrical signal indicates an optical power of the first filtered optical signal, and the second filtered electrical signal indicates an optical power of the second filtered optical signal.

The control unit 3C is configured to output a frequency difference control signal to the first laser based on the first filtered electrical signal and the second filtered electrical signal, where the frequency difference control signal is used to control the first laser to adjust a frequency difference between the first optical signal and the second optical signal to a first frequency difference.

In this embodiment of this application, the first optical signal and the second optical signal are input to the tunable comb filter 1C, to respectively obtain the first filtered optical signal and the second filtered optical signal. The first optical detection unit 2C separately performs optical-to-electrical conversion on the first filtered optical signal and the second filtered optical signal, to obtain the first filtered electrical signal and the second filtered electrical signal. Relative frequencies of the first optical signal and the second optical signal within one FSR of the tunable comb filter 1C are respectively obtained based on the first filtered electrical signal and the second filtered electrical signal, to obtain a relative frequency difference between the first optical signal and the second optical signal within the FSR. In some application scenarios, a quantity of FSRs (that is, a quantity of interval periods) between the first optical signal and the second optical signal on the tunable comb filter 1C is known, or may be directly obtained. In this case, an absolute frequency difference between the first optical signal and the second optical signal may be learned of based on a relative frequency difference within one FSR and a quantity of FSR periods that are obtained through calculation. The control unit 3C adjusts the first laser A based on the absolute frequency difference, to adjust a frequency of the first optical signal, so that the frequency difference between the first optical signal and the second optical signal remains at the first frequency difference. However, in some other application scenarios, the frequency difference between the first optical signal and the second optical signal can be adjusted without determining a quantity of FSR periods between the first optical signal and the second optical signal.

In some possible implementations, as shown in FIG. 7, when the laser generation apparatus 100 further includes the first laser A, a first transmit splitter A1 may be further disposed at an output end of the first laser A. When the laser generation apparatus 100 further includes the second laser B, a second transmit splitter B1 may be further disposed at an output end of the second laser B.

For descriptions of the first transmit splitter A1 and the second transmit splitter B1, refer to the related descriptions in the foregoing embodiments. Details are not described herein again.

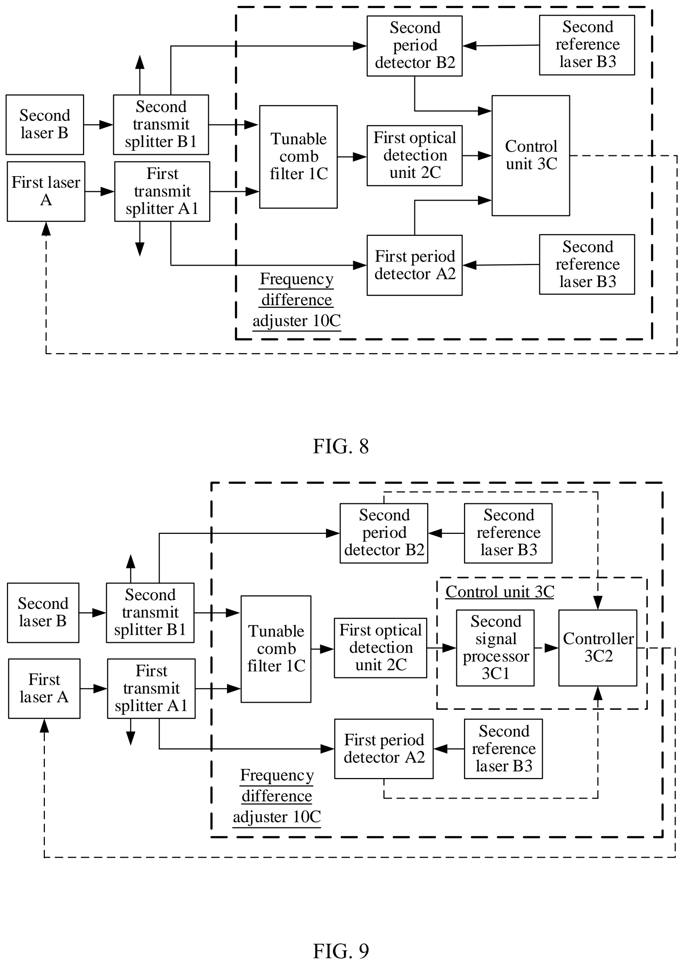

In some possible implementations, as shown in FIG. 8, the frequency difference adjuster 10C further includes a first period detector A2, a second period detector B2, a first reference laser A3, and a second reference laser B3.

The first reference laser A3 is configured to output a first reference optical signal to the first period detector A2, and the second reference laser B3 is configured to output a second reference optical signal to the second period detector B2, where a frequency period interval between the first reference optical signal and the second reference optical signal is fixed.

The first period detector A2 is configured to output a first interval signal to the control unit 3C based on the first optical signal and the first reference optical signal, where the first interval signal indicates a frequency period interval between the first optical signal and the first reference optical signal.

The second period detector B2 is configured to output a second interval signal to the control unit 3C based on the second optical signal and the second reference optical signal, where the second interval signal indicates a frequency period interval between the second optical signal and the second reference optical signal.

The control unit 3C is configured to:

output a first frequency control signal to the first laser A based on the first interval signal, where the first frequency control signal is used to control the first laser A to adjust a frequency of the first optical signal; or output a first frequency control signal to the first reference laser A3 based on the first interval signal, where the first frequency control signal is used to control the first reference laser A3 to adjust a frequency of the first reference optical signal; and

output a second frequency control signal to the second laser B based on the second interval signal, where the second frequency control signal is used to control the second laser B to adjust a frequency of the second optical signal.

For example, when the quantity of FSR periods between the first optical signal and the second optical signal is uncertain, and in a current application scenario, the absolute frequency difference between the first optical signal and the second optical signal needs to be determined based on the quantity of FSR periods between the first optical signal and the second optical signal, the first reference laser A3 and the second reference laser B3 may be disposed to generate the first reference optical signal and the second reference optical signal respectively. The first reference optical signal and the second reference optical signal are optical signals with fixed frequencies, and a quantity of FSR periods between the first reference optical signal and the second reference optical signal is fixed. The first period detector A1 and the second period detector B1 are frequency difference detection components that can be used to determine, within a specific range, whether a frequency between input optical signals is within a specific frequency period interval. The first optical signal and the first reference optical signal are input to the first period detector A1, and the first period detector A1 outputs the first interval signal to the control unit 3C based on the first optical signal and the first reference optical signal, where the first interval signal indicates a quantity of interval frequency periods between the first optical signal and the first reference optical signal. The control unit 3C outputs the first frequency control signal to the first laser A or the first reference laser A3 based on the first interval signal, so that a quantity of FSR periods between the first optical signal and the first reference optical signal is fixed by using the first frequency control signal, for example, the quantity of FSR periods between the first optical signal and the first reference optical signal is 0 (that is, the first optical signal and the first reference optical signal are in a same FSR period) or another fixed value. Similarly, the control unit 3C may obtain the second interval signal based on the second optical signal and the second reference optical signal, and output the second frequency control signal to the second laser B based on the second interval signal. The second frequency control signal is used to control the second laser B to adjust the frequency of the output second optical signal, so that a quantity of FSR frequency periods between the second optical signal and the second reference optical signal is fixed. For example, the quantity of FSR frequency periods between the second optical signal and the second reference optical signal is 0 or another fixed value. Because a quantity of FSR periods between the first reference optical signal and the second reference optical signal before adjustment is fixed, and a changed quantity of FSR periods during adjustment can be learned of, the quantity of FSR periods between the first optical signal and the second optical signal may be determined based on the changed quantity of FSR periods and the quantity of FSR periods between the first reference optical signal and the second reference optical signal before adjustment.

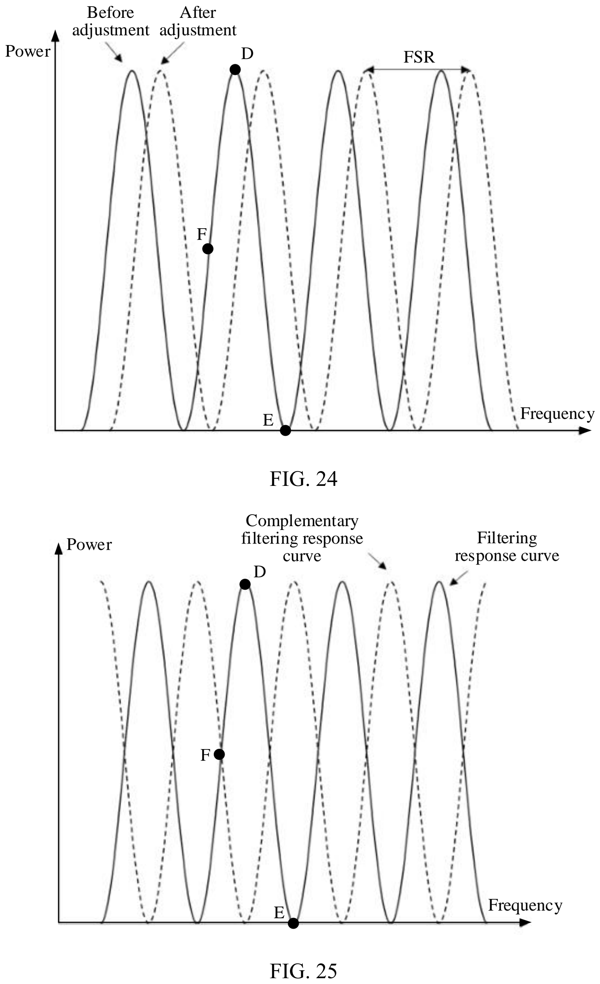

In some possible implementations, as shown in FIG. 23 and FIG. 24, the tunable comb filter 1C may be a sinusoidal tunable comb filter, a sawtooth tunable comb filter, or the like. Regardless of a type of the tunable comb filter, a function described in this embodiment of this application can be implemented.

In some possible implementations, a material of the tunable comb filter 1C may be, for example, silicon, silicon dioxide, lithium niobate, an III-V material (for example, indium phosphide), or a polymer.

In some possible implementations, a structure of the tunable comb filter 1C may be a planar reflection type, a Mach-Zehnder interference type, or the like.

In some possible implementations, the tunable comb filter 1C may be a thermally tunable comb filter, an electrically tunable comb filter, or the like.

In some possible implementations, as shown in FIG. 9, the control unit 3C includes a second signal processor 3C1 and a controller 3C2.

The second signal processor 3C1 is configured to output a frequency difference signal to the controller 3C2 based on the first filtered electrical signal and the second filtered electrical signal, where the frequency difference signal indicates the frequency difference between the first optical signal and the second optical signal.

The controller 3C2 is configured to output the frequency difference control signal to the first laser A based on the frequency difference signal.

In this embodiment of this application, the second signal processor 3C1 may determine a power of the first optical signal and a power of the second optical signal based on the first filtered electrical signal and the second filtered electrical signal, and determine the relative frequency difference between the first optical signal and the second optical signal based on the power of the first optical signal and the power of the second optical signal. Then, the second signal processor 3C1 outputs the frequency difference signal to the controller 3C2. The controller 3C2 outputs a responding frequency difference control signal based on the frequency difference signal, and controls, based on the frequency difference control signal, the first laser A to adjust the frequency of the first optical signal, so that the frequency difference between the first optical signal and the second optical signal remains at the first frequency difference.

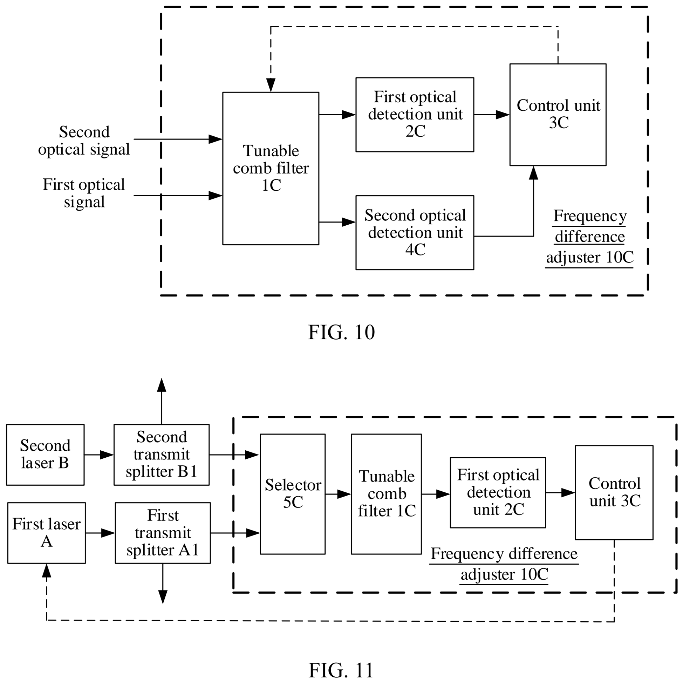

In some possible implementations, as shown in FIG. 10, the frequency difference adjuster 10C further includes a second optical detection unit 4C, and the second optical detection unit 4C is coupled to the control unit 3C.

The second optical detection unit 4C is configured to output a first electrical signal based on the first optical signal, and output a second electrical signal based on the second optical signal, where the first electrical signal indicates an optical power of the first optical signal, and the second electrical signal indicates an optical power of the second optical signal.

The control unit 3C is further configured to output a frequency adjustment signal to the tunable comb filter 1C based on the first electrical signal and the first filtered electrical signal, where the frequency adjustment signal is used to adjust a frequency of the tunable comb filter 1C.

For example, as shown in FIG. 22, FIG. 23, and FIG. 24, the second optical signal is used as an example. Theoretically, a corresponding frequency-power response relationship is definite after the second optical signal is input into the tunable comb filter 1C. Therefore, regardless of a frequency with any magnitude, there is a definite optical power value. However, a corresponding signal frequency may be better determined when an optical power has some special values, for example, when a value of the optical power is a maximum value, a minimum value, or a median value. As shown in FIG. 10, in this case, the first optical signal and the second optical signal may be input through the second optical detection unit 4C. In addition, the first electrical signal is obtained based on the first optical signal, and the second electrical signal is obtained based on the second optical signal. The control unit 3C may determine a first optical power ratio between the first optical signal and the first filtered optical signal based on the first electrical signal and the second filtered electrical signal, and determine a position of the second optical signal on a frequency-power response curve of the tunable comb filter 1C based on the second optical power ratio. Similarly, the second signal processor 3C1 in the control unit 3C may determine a second optical power ratio between the second optical signal and the second filtered optical signal based on the second electrical signal and the second filtered electrical signal, and determine a position of the second optical signal on the frequency-power response curve of the tunable comb filter 1C based on the second optical power ratio.

For example, the controller 3C2 may further adjust a period of the tunable comb filter 1C based on the second optical power ratio between the second electrical signal and the second filtered electrical signal, to adjust a frequency value of the second filtered optical signal to a maximum value, a minimum value, a median value, or the like. As shown in FIG. 23 and FIG. 24, when the frequency value of the second filtered optical signal is a maximum value, it indicates that the frequency of the second optical signal corresponds to a frequency D that responds to a maximum power in one FSR frequency period. When the frequency value of the second filtered optical signal is a minimum value, it indicates that the frequency of the second optical signal corresponds to a frequency E that responds to a minimum power in one FSR frequency period. When the frequency value of the second filtered optical signal is a median value, it indicates that the frequency of the second optical signal corresponds to a frequency F with a largest slope in a frequency-power response relationship in one FSR frequency period. The frequency of the tunable comb filter 1C is adjusted, so that the frequency of the second optical signal corresponds to special frequencies such as the frequency D, the frequency E, and the frequency F. Then, when the first laser A is adjusted, the frequency of the first optical signal also corresponds to a frequency D, a frequency E, and a frequency F in an FSR frequency period, so that adjustment of the first frequency difference is more convenient and precise. In FIG. 23 and FIG. 24, a solid line is a response curve before the frequency of the tunable comb filter 1C is adjusted, and a dashed line is a response curve after the frequency of the tunable comb filter 1C is adjusted.

In some possible implementations, the tunable comb filter 1C is a non-complementary tunable comb filter. As shown in FIG. 22, FIG. 23, and FIG. 24, a signal output by the non-complementary tunable comb filter represents a frequency-power response relationship for an optical signal (where the relationship may be of a sawtooth type, a sinusoidal type, or the like, and the sinusoidal type is used as an example in FIG. 24).

In this embodiment of this application, the non-complementary tunable comb filter may respectively output the first filtered optical signal and the second filtered optical signal based on the first optical signal and the second optical signal, and obtain the first filtered electrical signal and the second filtered electrical signal based on the first filtered optical signal and the second filtered optical signal. The first filtered electrical signal may indicate the optical power of the first filtered optical signal. The sinusoidal frequency-power response relationship shown in FIG. 24 is used as an example, and the optical power and the frequency of the first filtered optical signal periodically change based on a sinusoidal relationship. In this case, the optical power of the first filtered optical signal may reflect a relative frequency value of the first optical signal in one FSR period. Similarly, the optical power of the second filtered optical signal may also reflect a relative frequency value of the second optical signal in one FSR period. The control unit 3C may obtain the relative frequency difference between the first optical signal and the second optical signal based on the first filtered electrical signal and the second filtered electrical signal.

In some possible implementations, when the tunable comb filter 1C is a non-complementary tunable comb filter, the frequency difference may be adjusted by controlling time at which the first optical signal is input to the tunable comb filter 1C and time at which the second optical signal is input to the tunable comb filter 1C.

The non-complementary tunable comb filter shown in FIG. 23 and FIG. 24 is used as an example. Based on FIG. 6, FIG. 7, FIG. 8, FIG. 9, and FIG. 10, as shown in FIG. 11, the frequency difference adjuster 10C further includes a selector 5C. The selector 5C is coupled to the control unit 3C and the tunable comb filter 1C. The selector is configured to input the first optical signal and the second optical signal.

The control unit is further configured to control the selector to output the first optical signal or the second optical signal to the tunable comb filter and the second optical detection unit through a first splitter.

In this embodiment of this application, the control unit 3C controls the selector 5C to output the first optical signal or the second optical signal. The first optical signal and the second optical signal are separately output, so that the tunable comb filter 1C and the first optical detection unit 2C can be reused. The control unit 3C determines the frequency difference between the first optical signal and the second optical signal based on the first filtered electrical signal and the second filtered electrical signal that are separately output by the first optical detection unit.

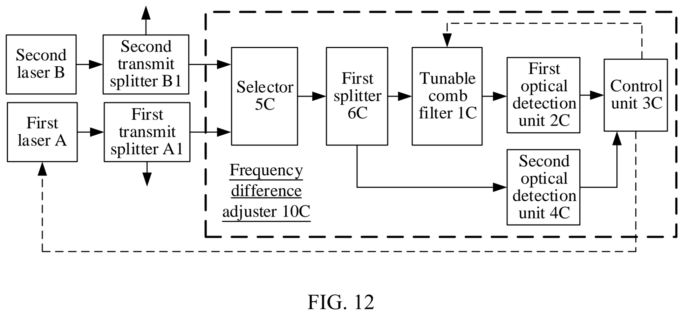

For example, based on FIG. 6, FIG. 7, FIG. 8, FIG. 9, FIG. 10, and FIG. 11, as shown in FIG. 12, when the frequency difference adjuster 10C includes the second optical detection unit 4C mentioned in the foregoing embodiment, the frequency difference adjuster 10C may further include a first splitter 6C. The selector 5C is coupled to the first splitter 6C. The first splitter 6C is coupled to the tunable comb filter 1C and the second optical detection unit 4C. The control unit 3C is configured to control the selector 5C to output the first optical signal or the second optical signal to the tunable comb filter 1C and the second optical detection unit 4C through the first splitter 6C.

For example, when outputting the first optical signal, the selector 5C outputs the input first optical signal to the tunable comb filter 1C and the second optical detection unit 4C through the first splitter 6C. The tunable comb filter 1C filters the input first optical signal to obtain the first filtered optical signal, and outputs the first filtered optical signal to the first optical detection unit 2C. The first optical detection unit 2C converts the input first filtered optical signal into the first filtered electrical signal, and outputs the first filtered electrical signal to the control unit 3C. In this case, the second optical detection unit 4C converts the input first optical signal into the first electrical signal, and outputs the first electrical signal to the control unit 3C. The control unit 3C obtains a ratio between the optical power of the first optical signal and the optical power of the first filtered optical signal based on the input first electrical signal and the input first filtered electrical signal, to determine a frequency value of the first optical signal in one FSR frequency period of the tunable comb filter 1C.

For example, when outputting the second optical signal, the selector 5C outputs the input second optical signal to the tunable comb filter 1C and the second optical detection unit 4C through the first splitter 6C. The tunable comb filter 1C filters the input second optical signal to obtain the second filtered optical signal, and outputs the second filtered optical signal to the first optical detection unit 2C. The first optical detection unit 2C converts the input second filtered optical signal into the second filtered electrical signal, and outputs the second filtered electrical signal to the control unit 3C. In this case, the second optical detection unit 4C converts the input second optical signal into the second electrical signal, and outputs the second electrical signal to the control unit 3C. The control unit 3C obtains a ratio between the optical power of the second optical signal and the optical power of the second filtered optical signal based on the input second electrical signal and the input second filtered electrical signal, to determine a frequency value of the second optical signal in one FSR frequency period of the tunable comb filter 1C.

In this embodiment of this application, the selector 5C is controlled to output the first optical signal or the second optical signal, so that the first optical signal and the second optical signal are separately input to the tunable comb filter 1C and the second optical detection unit 4C, to reuse the tunable comb filter 1C and the second optical detection unit 4C. In this case, both the first optical signal and the second optical signal are filtered and output by the tunable comb filter 1C. In this case, a quantity of frequency difference adjusters 10 is decreased, and there is no need to calibrate the frequency-power response relationship for the tunable comb filter 1C based on different temperatures.

In some possible implementations, when the tunable comb filter 1C is a non-complementary tunable comb filter, the first optical signal and the second optical signal may be simultaneously input to the tunable comb filter 1C, and then the frequency difference is adjusted through demultiplexing.

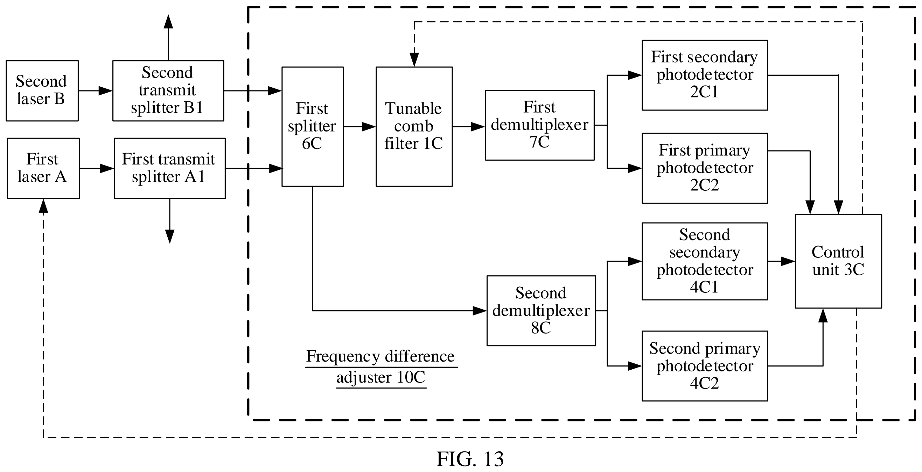

For example, based on FIG. 6, FIG. 7, FIG. 8, FIG. 9, and FIG. 10, as shown in FIG. 13, the frequency difference adjuster 10C further includes a first splitter 6C, a first demultiplexer 7C, and a second demultiplexer 8C, the first optical detection unit 2C includes a first secondary photodetector 2C1 and a first primary photodetector 2C2, and the second optical detection unit 4C includes a second secondary photodetector 4C1 and a second primary photodetector 4C2. An output end of the first splitter 6C is coupled to an input end of the tunable comb filter 1C and an input end of the second demultiplexer 8C, and the first splitter 6C is configured to input the first optical signal and the second optical signal. An output end of the tunable comb filter 1C is coupled to an input end of the first demultiplexer 6C. An output end of the first demultiplexer 7C is coupled to an input end of the first primary photodetector 2C2 and an input end of the first secondary photodetector 2C1. An output end of the second demultiplexer 8C is coupled to an input end of the second primary photodetector 4C2 and an input end of the second secondary photodetector 4C1. An output end of the first primary photodetector 2C2, an output end of the first secondary photodetector 2C1, an output end of the second primary photodetector 4C2, and an output end of the second secondary photodetector 4C1 are coupled to the control unit 3C.

For example, the first splitter 6C is configured to input the first optical signal and the second optical signal, and output a mixed optical signal to the tunable comb filter 1C and the second demultiplexer 8C, where the mixed optical signal includes the first optical signal and the second optical signal. The tunable comb filter 1C is configured to output a mixed filtered optical signal to the first demultiplexer 7C based on the mixed optical signal, where the mixed filtered optical signal includes the first filtered optical signal and the second filtered optical signal. The first demultiplexer 7C is configured to output the first filtered optical signal to the first secondary photodetector 2C1, and output the second filtered optical signal to the first primary photodetector 2C2. The second demultiplexer 8C is configured to output the first optical signal to the second secondary photodetector 4C1, and output the second optical signal to the second primary photodetector 4C2. The first secondary photodetector 2C1 is configured to output the first filtered electrical signal to the control unit 3C based on the first filtered optical signal. The first primary photodetector 2C2 is configured to output the second filtered electrical signal to the control unit 3C based on the second filtered optical signal. The second secondary photodetector 4C1 is configured to output the first electrical signal to the control unit 3C based on the first optical signal. The second primary photodetector 4C2 is configured to output the second electrical signal to the control unit 3C based on the second optical signal.

In this embodiment of this application, the mixed optical signal including the first optical signal and the second optical signal is input to the tunable comb filter 1C, and the first demultiplexer 7C demultiplexes the first filtered optical signal and the second filtered optical signal. The first filtered optical signal is input to the first secondary photodetector 2C1, optical-to-electrical conversion is performed to obtain the first filtered electrical signal, and the first filtered electrical signal is output to the control unit 3C. The second filtered optical signal is input to the first primary photodetector 2C2, optical-to-electrical conversion is performed to obtain the second filtered electrical signal, and the second filtered electrical signal is output to the control unit 3C. After the mixed optical signal is input to the second demultiplexer 8C, the second demultiplexer 8C outputs the first optical signal to the second secondary photodetector 4C1, and outputs the second optical signal to the second primary photodetector 4C2. The second secondary photodetector 4C1 performs optical-to-electrical conversion on the first optical signal, and outputs the first electrical signal to the control unit 3C. The second primary photodetector 4C2 performs optical-to-electrical conversion on the second optical signal, and outputs the second electrical signal to the control unit 3C. The control unit 3C determines a ratio between the optical power of the first optical signal and the optical power of the first filtered optical signal based on the first electrical signal and the first filtered electrical signal, to determine a frequency value of the first optical signal in one FSR frequency period of the tunable comb filter 1C. The control unit 3C determines a ratio between the optical power of the second optical signal and the optical power of the second filtered optical signal based on the second electrical signal and the second filtered electrical signal, to determine a frequency value of the second optical signal in one FSR frequency period of the tunable comb filter 1C. Based on the embodiment in FIG. 13 in this application, the demultiplexers are used to perform demultiplexing, so that the tunable comb filter 1C can simultaneously input the first optical signal and the second optical signal for processing. Compared with the solution in which the selector 5C used in the embodiment in FIG. 11 and FIG. 12 is controlled to separately input the first optical signal and the second optical signal to the tunable comb filter 1C, in this solution, a control procedure is shortened, and a speed of controlling adjustment of the frequency of the first optical signal is accelerated.

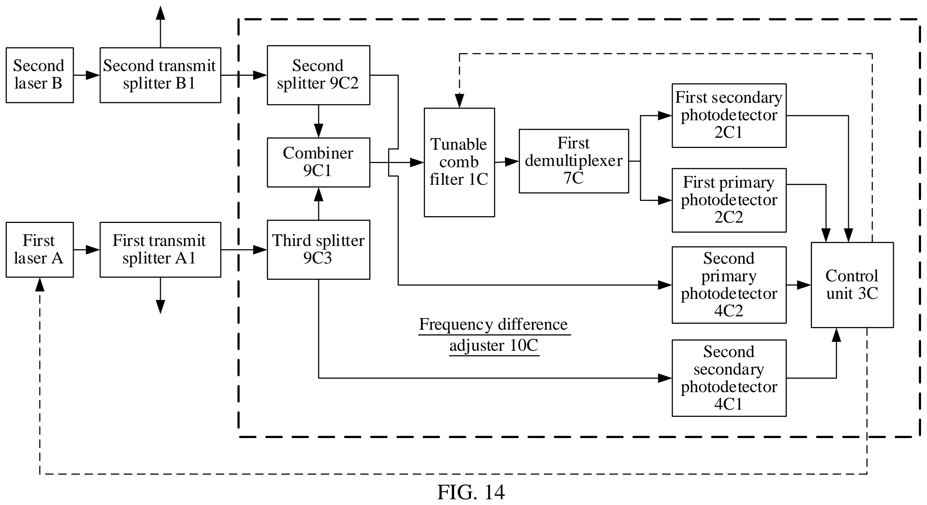

For example, based on FIG. 6, FIG. 7, FIG. 8, FIG. 9, and FIG. 10, as shown in FIG. 14, the frequency difference adjuster 10C further includes a combiner 9C1, a second splitter 9C2, a third splitter 9C3, and a first demultiplexer 7C, the first optical detection unit 2C includes a first secondary photodetector 2C1 and a first primary photodetector 2C2, and the second optical detection unit 4C includes a second secondary photodetector 4C1 and a second primary photodetector 4C2. An output end of the second splitter 9C2 is coupled to an input end of the combiner 9C1 and an input end of the second primary photodetector 4C2, and the second splitter 9C2 is configured to input the second optical signal. An output end of the third splitter 9C3 is coupled to the input end of the combiner 9C1 and an input end of the second secondary photodetector 4C1, and the third splitter 9C3 is configured to input the first optical signal. An output end of the combiner 9C1 is coupled to an input end of the tunable comb filter 1C, and an output end of the tunable comb filter 1C is coupled to an input end of the first demultiplexer 7C. An output end of the first demultiplexer 7C is coupled to an input end of the first primary photodetector 2C2 and an input end of the first secondary photodetector 2C1. An output end of the first primary photodetector 2C2, an output end of the first secondary photodetector 2C1, an output end of the second primary photodetector 4C2, and an output end of the second secondary photodetector 4C1 are coupled to the control unit 3C.

For example, the second splitter 9C2 is configured to input the second optical signal, and output the second optical signal to the combiner 9C1 and the second primary photodetector 4C2. The third splitter 9C3 is configured to input the first optical signal, and output the first optical signal to the combiner 9C1 and the second secondary photodetector 4C1. The combiner 9C1 is configured to output a mixed optical signal to the tunable comb filter 1C, where the mixed optical signal includes the first optical signal and the second optical signal. The tunable comb filter 1C is configured to output a mixed filtered optical signal to the first demultiplexer 7C based on the mixed optical signal, where the mixed filtered optical signal includes the first filtered optical signal and the second filtered optical signal. The first demultiplexer 7C is configured to output the first filtered optical signal to the first secondary photodetector 2C1, and output the second filtered optical signal to the first primary photodetector 2C2. The first secondary photodetector 2C1 is configured to output the first filtered electrical signal to the control unit 3C based on the first filtered optical signal. The first primary photodetector 2C2 is configured to output the second filtered electrical signal to the control unit 3C based on the second filtered optical signal. The second secondary photodetector 4C1 is configured to output the first electrical signal to the control unit 3C based on the first optical signal. The second primary photodetector 4C2 is configured to output the second electrical signal to the control unit 3C based on the second optical signal.

In this embodiment of this application, the second splitter 9C2 inputs the second optical signal and splits the second optical signal into two signals, where one signal is output to the combiner 9C1, and the other signal is output to the second primary photodetector 4C2. The second splitter 9C3 inputs the first optical signal and splits the first optical signal into two signals, where one signal is output to the combiner 9C1, and the other signal is output to the second secondary photodetector 4C1. After the first optical signal and the second optical signal are input to the combiner 9C1, the combiner 9C1 outputs the mixed optical signal to the tunable comb filter 1C. Compared with the structure in FIG. 13, based on the structure in FIG. 14 in this embodiment of this application, one demultiplexer is reduced, and a quantity of splitters is increased. In addition, compared with the solutions in FIG. 11 and FIG. 12, the solution shown in FIG. 14 also shortens a control procedure, and accelerates a speed of controlling adjustment of the first optical signal output by the first laser A.

In some possible implementations, the tunable comb filter 1C is a complementary tunable comb filter. As shown in FIG. 25, one optical signal is input to the complementary tunable comb filter, to obtain a filtered optical signal and a complementary filtered optical signal. A frequency-power response relationship for the filtered optical signal and a frequency-power response relationship for the complementary filtered optical signal are reversed.

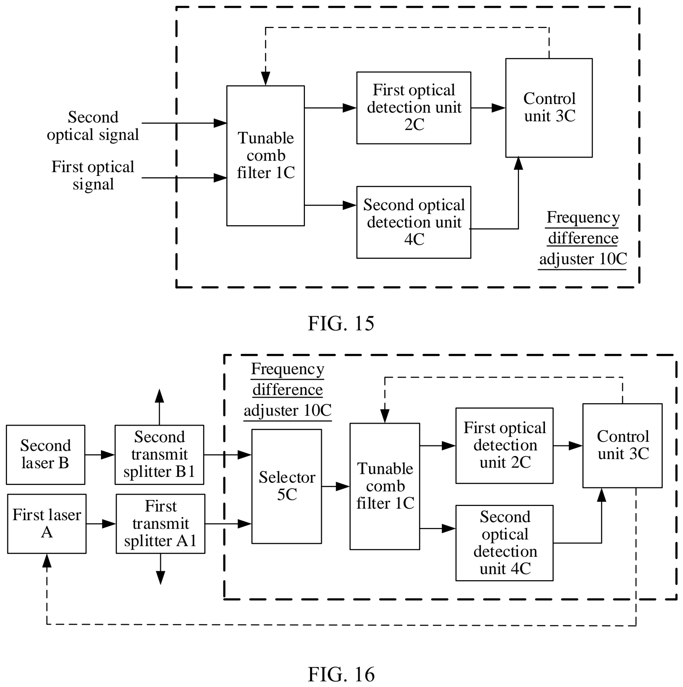

For example, when the tunable comb filter 1C is a complementary tunable comb filter, based on FIG. 6, FIG. 7, FIG. 8, and FIG. 9, as shown in FIG. 15, the frequency difference adjuster 10C further includes a second optical detection unit 4C, and the tunable comb filter 1C is further coupled to the control unit 3C through the second optical detection unit 4C.

For example, as shown in FIG. 15, the tunable comb filter 1C is configured to output the first filtered optical signal to the first optical detection unit 2C based on the first optical signal, and output the second filtered optical signal to the first optical detection unit 2C based on the second optical signal; and output a first complementary filtered optical signal to the second optical detection unit 4C based on the first optical signal, and output a second complementary filtered optical signal to the second optical detection unit 4C based on the second optical signal. A frequency-power response relationship for the first filtered optical signal and a frequency-power response relationship for the first complementary filtered optical signal are reversed, and a frequency-power response relationship for the second filtered optical signal and a frequency-power response relationship for the second complementary filtered optical signal are reversed.

The first optical detection unit 2C is configured to output a first filtered electrical signal based on the first filtered optical signal, and output a second filtered electrical signal based on the second filtered optical signal, where the first filtered electrical signal indicates an optical power of the first filtered optical signal, and the second filtered electrical signal indicates an optical power of the second filtered optical signal. The second optical detection unit 4C is configured to output a first complementary filtered electrical signal based on the first complementary filtered optical signal, and output a second complementary filtered electrical signal based on the second complementary filtered optical signal, where the first complementary filtered electrical signal indicates an optical power of the first complementary filtered optical signal, and the second complementary filtered electrical signal indicates an optical power of the second complementary filtered optical signal.

The control unit 3C is specifically configured to output a frequency adjustment signal to the tunable comb filter 1C based on the second complementary filtered electrical signal and the second filtered electrical signal, where the frequency adjustment signal is used to adjust a frequency of the tunable comb filter 1C; output a first frequency control signal to the first laser A based on the first filtered electrical signal and the first complementary filtered electrical signal; output a second frequency control signal to a second laser B based on the second filtered electrical signal and the second complementary filtered electrical signal; and output the frequency difference control signal to the first laser A based on the first filtered electrical signal, the second filtered electrical signal, the first complementary filtered electrical signal, and the second complementary filtered electrical signal.

In this embodiment of this application, when the tunable comb filter 1C is a complementary tunable comb filter, for one optical signal, one filtered optical signal and one complementary filtered optical signal may be obtained, and frequency-power response relationships for the two optical signals are reversed. A change rate of an optical power difference between the filtered optical signal and the complementary filtered optical signal is greater than a change rate of an optical power difference between the filtered optical signal and the optical signal input to the tunable comb filter 1C. Therefore, compared with a non-complementary tunable comb filter, the complementary tunable comb filter can be used to more easily adjust a frequency value of the first optical signal and a frequency value of the second optical signal in one FSR frequency period of the tunable comb filter 1C.

For example, when the tunable comb filter 1C is a complementary tunable comb filter, based on FIG. 6, FIG. 7, FIG. 8, and FIG. 9, as shown in FIG. 16, the frequency difference adjuster 10C further includes a selector 5C, and the selector 5C is coupled to the tunable comb filter 1C. The selector 5C is configured to input the first optical signal and the second optical signal. The control unit 3C is further configured to control the selector 5C to output the first optical signal or the second optical signal to the tunable comb filter 1C.

In this embodiment of this application, the selector 5C controls to input the first optical signal or the second optical signal to the tunable comb filter 1C, so that one frequency difference adjuster 10C is reused. For an application principle and a technical effect of the selector 5C in the embodiment in FIG. 16, refer to the descriptions of the embodiments related to FIG. 11 and FIG. 12. Details are not described herein again.

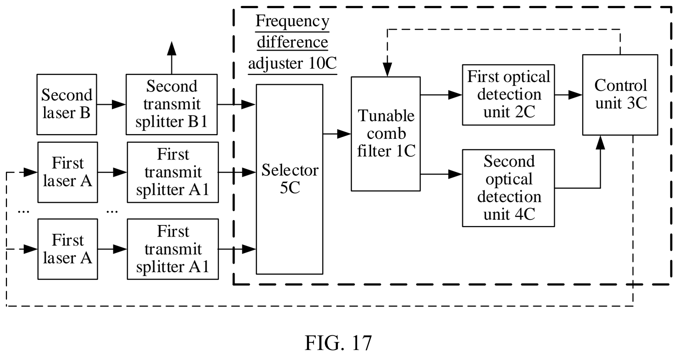

For example, based on FIG. 6, FIG. 7, FIG. 8, FIG. 9, and FIG. 16, as shown in FIG. 17, there may be a plurality of first lasers A. The control unit 3C controls the selector 5C to input, to the tunable comb filter 1C, a first optical signal output by one of the plurality of first lasers A, or the control unit 3C controls the selector 5C to input, to the tunable comb filter 1C, a second optical signal output by a second laser B.

In this embodiment of this application, the frequency difference adjuster 10 may be reused through the selector 5C, and a frequency of the second optical signal is used as a reference to adjust frequencies of first optical signals output by the plurality of first lasers A. Adjusted frequencies of the plurality of first optical signals may be the same or different.

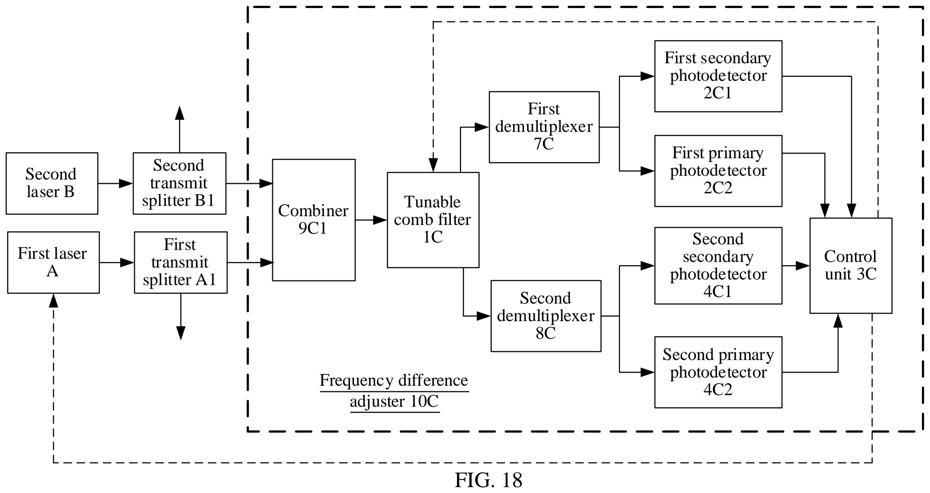

For example, when the tunable comb filter 1C is a complementary tunable comb filter, based on FIG. 6, FIG. 7, FIG. 8, and FIG. 9, as shown in FIG. 18, the frequency difference adjuster includes a combiner 9C1, a first demultiplexer 7C, and a second demultiplexer 8C, the first optical detection unit 2C includes a first primary photodetector 2C2 and a first secondary photodetector 2C1, and the second optical detection unit 4C includes a second primary photodetector 4C2 and a second secondary photodetector 4C1.

An output end of the combiner 9C1 is coupled to an input end of the tunable comb filter 1C, and the combiner 9C1 is configured to input the first optical signal and the second optical signal. An output end of the tunable comb filter 1C is coupled to an input end of the first demultiplexer 7C and an input end of the second demultiplexer 8C. An output end of the first demultiplexer 7C is coupled to an input end of the first primary photodetector 2C2 and an input end of the first secondary photodetector 2C1. An output end of the second demultiplexer 8C is coupled to an input end of the second primary photodetector 4C2 and an input end of the second secondary photodetector 4C1. An output end of the first primary photodetector 2C2, an output end of the first secondary photodetector 2C1, an output end of the second primary photodetector 4C2, and an output end of the second secondary photodetector 4C1 are coupled to the control unit 3C.

In this embodiment of this application, as shown in FIG. 18, the combiner 9C1 is configured to input the first optical signal and the second optical signal, and output a mixed optical signal to the tunable comb filter 1C, where the mixed optical signal includes the first optical signal and the second optical signal. The tunable comb filter 1C is configured to output a mixed filtered optical signal to the first demultiplexer 7C based on the mixed optical signal, and output a mixed complementary filtered optical signal to the second demultiplexer 8C, where the mixed filtered optical signal includes the first filtered optical signal and the second filtered optical signal, and the mixed complementary filtered optical signal includes a first complementary filtered optical signal and a second complementary filtered optical signal. The first demultiplexer 7C is configured to output the first filtered optical signal to the first secondary photodetector 2C1, and output the second filtered optical signal to the first primary photodetector 2C2. The second demultiplexer 8C is configured to output the first complementary filtered optical signal to the second secondary photodetector 4C1, and output the second complementary filtered optical signal to the second primary photodetector 4C2.

The first secondary photodetector is configured to output the first filtered electrical signal to the control unit based on the first filtered optical signal. The first primary photodetector is configured to output the second filtered electrical signal to the control unit based on the second filtered optical signal. The second secondary photodetector is configured to output a first complementary filtered electrical signal to the control unit based on the first complementary filtered optical signal. The second primary photodetector is configured to output a complementary filtered second electrical signal to the control unit based on the second complementary filtered optical signal.

In this embodiment of this application, based on power differences indicated by the complementary filtered electrical signals and the filtered electrical signals, a frequency value can be more easily determined, and one FSR frequency period of the tunable comb filter 1C can be adjusted to be aligned with the frequencies of the second optical signal and the first optical signal. In addition, the combiner 9C1 outputs the mixed optical signal to the tunable comb filter 1C. Compared with controlling the first optical signal or the second optical signal through the selector 5C, this reduces a control procedure, and accelerates a speed of controlling adjustment of the frequency difference between the first optical signal and the second optical signal to the first frequency difference.

In this embodiment of this application, the second optical signal is used as a reference optical signal, and a frequency value of one or more first optical signals is adjusted based on the frequency value of the second optical signal.

In some possible implementations, the frequency difference adjuster 10C may be disposed as an independent component. A pluggable control interface is usually disposed on the first laser A. The frequency difference adjuster 10C receives the first optical signal and the second optical signal, and outputs the frequency difference control signal to the first laser A through the control interface on the first laser A, to adjust the frequency difference between the first optical signal and the second optical signal to the first frequency difference.

For example, the frequency difference adjuster 10C may be used in application scenarios such as laser calibration, inspection, and production.

In some possible implementations, the laser generation apparatus 100 includes the first laser A and the frequency difference adjuster 10C. In this case, the laser generation apparatus 100 may be considered as a laser component that can perform automatic alignment. The laser generation apparatus 100 receives a second optical signal, and calibrates a frequency of an output first optical signal based on the second optical signal.

In some possible implementations, the laser generation apparatus 100 includes the first laser A, the second laser B, and the frequency difference adjuster 10C. In this case, the laser generation apparatus 100 is a laser component that can output a plurality of optical signals with a fixed frequency difference.

In some possible implementations, the electronic device 1000 may be a laser output device, an inspection equipment, a gas detection device, a communication device, a calibration device (like a wavelength meter), or the like.

For example, in some communication application scenarios, one or more pairs of optical signals with a fixed frequency difference need to be used to generate radio frequency signals of different frequency bands in a manner like coherent beat frequency modulation. In this case, it needs to be ensured that a frequency difference between a plurality of optical signals output by a laser that provides an optical signal used for beat frequency is fixed in real time (where frequencies of the optical signals may change, but the frequency difference between the optical signals is fixed). In this case, the frequency difference between the plurality of optical signals may be dynamically adjusted through the frequency difference adjuster 10C and the laser generation apparatus 100 that are described in the foregoing embodiments.

Based on the frequency difference adjuster 10C including the structures shown in FIG. 6, FIG. 7, FIG. 8, FIG. 9, FIG. 10, FIG. 11, FIG. 12, FIG. 13, FIG. 14, FIG. 15, FIG. 16, FIG. 17, and FIG. 18, the following frequency difference adjustment method may be performed.

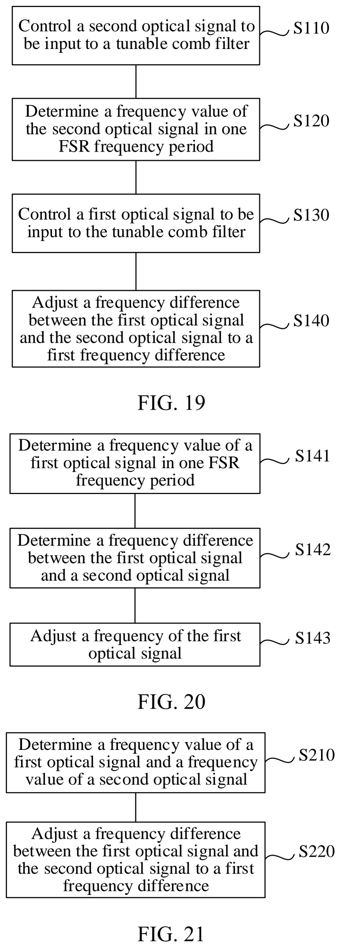

In some possible implementations, a frequency difference may be adjusted by controlling time at which a first optical signal is input to the tunable comb filter 1C and time at which a second optical signal is input to the tunable comb filter 1C. In this case, the frequency difference adjustment method includes operations in step S110 to step S140 shown in FIG. 19.

S110: Control the second optical signal to be input to the tunable comb filter 1C.

For example, as shown in FIG. 11, FIG. 12, FIG. 16, and FIG. 17, the control unit 3C controls the selector 5C to output the input second optical signal to the tunable comb filter 1C. Then, the tunable comb filter 1C outputs a second filtered optical signal based on the input second optical signal. The first optical detection unit 2C converts the second filtered optical signal into a second filtered electrical signal, and outputs the second filtered electrical signal to the control unit 3C.

S120: Determine a frequency value of the second optical signal in one FSR frequency period.

For example, as shown in FIG. 6, FIG. 7, FIG. 8, FIG. 9, FIG. 10, FIG. 11, FIG. 12, FIG. 16, and FIG. 17, the control unit 3C may determine a relative position of the second optical signal in one FSR frequency period based on an optical power indicated by the second filtered electrical signal.

For example, as shown in FIG. 10, FIG. 11, and FIG. 12, the second optical signal is further input to the second optical detection unit 4C, and a second electrical signal is output. The control unit 3C determines the relative position of the second optical signal in one FSR frequency period based on a ratio between the second electrical signal and the second filtered electrical signal.

For example, as shown in FIG. 15, FIG. 16, and FIG. 17, the control unit 3C determines the relative position of the second optical signal in one FSR frequency period based on an optical power ratio between the optical power indicated by the second filtered electrical signal and an optical power indicated by a second complementary filtered electrical signal.

For example, as shown in FIG. 6, FIG. 7, FIG. 8, FIG. 9, FIG. 10, FIG. 11, FIG. 12, FIG. 16, and FIG. 17, the control unit 3C may further adjust a frequency of the tunable comb filter 1C, so that the frequency of the second optical signal is at a frequency in one FSR frequency period of the tunable comb filter 1C, for example, a frequency D, a frequency E, and a frequency F shown in FIG. 23 and FIG. 24.

In this embodiment of this application, the frequency of the tunable comb filter 1C is adjusted, so that the frequency value of the second optical signal is aligned with a special frequency in one FSR frequency period, to facilitate subsequent adjustment of a frequency difference. Optionally, in one FSR frequency period, there is a largest change in a slope of the frequency F in a frequency-power response relationship. Therefore, in an actual operation, the frequency F is aligned with the frequency of the second optical signal more easily.

S130: Control the first optical signal to be input to the tunable comb filter 1C.

For example, as shown in FIG. 11, FIG. 12, FIG. 16, and FIG. 17, the control unit 3C controls the selector 5C to output the input first optical signal to the tunable comb filter 1C. Then, the tunable comb filter 1C outputs a first filtered optical signal based on the input first optical signal. The first optical detection unit 2C converts the first filtered optical signal into a first filtered electrical signal, and outputs the first filtered electrical signal to the control unit 3C.

S140: Adjust a frequency difference between the first optical signal and the second optical signal to a first frequency difference.

In some possible implementations, as shown in FIG. 20, step S140 may include the following operations in step S141 to step S143.

S141: Determine a frequency value of the first optical signal in one FSR frequency period.

For example, as shown in FIG. 6, FIG. 7, FIG. 8, FIG. 9, FIG. 10, FIG. 11, FIG. 12, FIG. 15, FIG. 16, and FIG. 17, the control unit 3C may determine a relative position of the first optical signal in one FSR frequency period based on an optical power indicated by the first filtered electrical signal.

For example, as shown in FIG. 10, FIG. 11, and FIG. 12, the first optical signal is further input to the second optical detection unit 4C, and a first electrical signal is output. The control unit 3C determines the relative position of the first optical signal in one FSR frequency period based on a ratio between the first electrical signal and the first filtered electrical signal.

For example, as shown in FIG. 16 and FIG. 17, the relative position of the first optical signal in one FSR frequency period is determined based on an optical power ratio between the optical power indicated by the first filtered electrical signal and an optical power indicated by a first complementary filtered electrical signal.

S142: Determine the frequency difference between the first optical signal and the second optical signal.

In some possible implementations, as shown in FIG. 6, FIG. 7, FIG. 8, FIG. 9, FIG. 10, FIG. 11, FIG. 12, FIG. 16, and FIG. 17, in some application scenarios, the control unit 3C does not need to determine a quantity of FSR frequency periods between the first optical signal and the second optical signal. A relative frequency difference between the first optical signal and the second optical signal is determined based on a relative frequency value of the first optical signal and a relative frequency value of the second optical signal in one FSR frequency period.

For example, a formula for calculating the relative frequency difference between the first optical signal and the second optical signal is as follows:

$$dx = \begin{cases} f1 - f2, Fs > Fm \\ f1 - f2, Fs < Fm \end{cases}$$

In the formula, dx represents the relative frequency difference between the first optical signal and the second optical signal, $f1$ represents a difference between a frequency value of the first optical signal in one FSR frequency period and a start frequency value of the FSR frequency period, $f2$ represents a difference between a frequency value of the second optical signal in one FSR frequency period and a start frequency value of the FSR frequency period, $Fs$ represents a frequency value of the first optical signal, and $Fm$ represents a frequency value of the second optical signal.

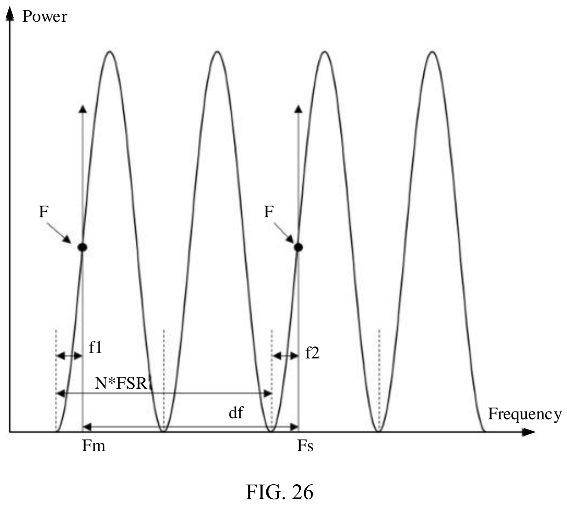

In some possible implementations, as shown in FIG. 6, FIG. 7, FIG. 8, FIG. 9, FIG. 10, FIG. 11, FIG. 12, FIG. 16, and FIG. 17, in some application scenarios, as shown in FIG. 26, the quantity of FSR frequency periods between the first optical signal and the second optical signal is known. In this case, the control unit 3C may determine an absolute frequency difference between the first optical signal and the second optical signal based on the quantity of FSR frequency periods between the first optical signal and the second optical signal and the relative frequency difference in one FSR frequency period.

For example, a formula for calculating the absolute frequency difference between the first optical signal and the second optical signal is as follows:

$$df = Fs - Fm = \begin{cases} N * FSR - (f1 - f2), Fs > Fm \\ -N * FSR - (f1 - f2), Fs < Fm \end{cases}$$

In the formula, df represents the absolute frequency difference between the first optical signal and the second optical signal, $f1$ represents a difference between a frequency value of the first optical signal in one FSR frequency period and a start frequency value of the FSR frequency period, $f2$ represents a difference between a frequency value of the second optical signal in one FSR frequency period and a start frequency value of the FSR frequency period, $Fs$ represents a frequency value of the first optical signal, $Fm$ represents a frequency value of the second optical signal, and N represents the quantity of FSR frequency periods between the first optical signal and the second optical signal.

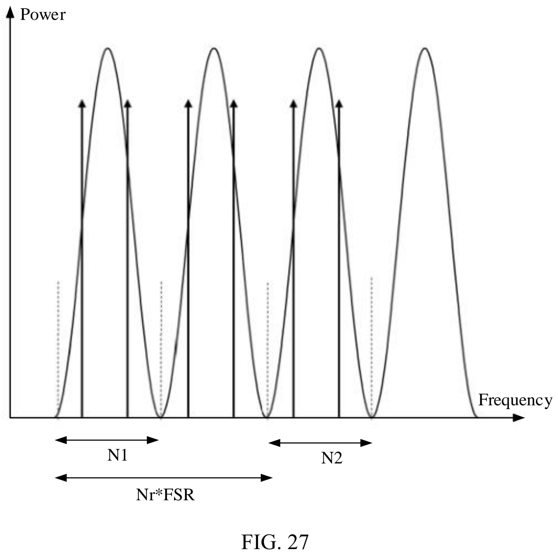

In some possible implementations, in some application scenarios, the quantity of interval FSR frequency periods needs to be determined. In some possible implementations, as shown in FIG. 8, the first reference laser A3, the second reference laser B3, the first period detector A2, and the second period detector B2 are further disposed in the frequency difference adjuster 10C. The first optical signal and the first reference optical signal are input to the first period detector A1, and the first period detector A1 outputs the first interval signal to the control unit 3C based on the first optical signal and the first reference optical signal, where the first interval signal indicates a quantity of interval FSR frequency periods between the first optical signal and the first reference optical signal. The control unit 3C outputs the first frequency control signal to the first laser A or the first reference laser A3 based on the first interval signal, so that a quantity of FSR periods between the first optical signal and the first reference optical signal is fixed by using the first frequency control signal, for example, the quantity of FSR periods between the first optical signal and the first reference optical signal is 0 (that is, the first optical signal and the first reference optical signal are in a same FSR period) or another fixed value. Similarly, the control unit 3C may obtain the second interval signal based on the second optical signal and the second reference optical signal, and output the second frequency control signal to the second laser B based on the second interval signal. The second frequency control signal is used to control the second laser B to adjust the frequency of the output second optical signal, so that a quantity of FSR frequency periods between the second optical signal and the second reference optical signal is fixed. For example, the quantity of FSR frequency periods between the second optical signal and the second reference optical signal is 0 or another fixed value. As shown in FIG. 27, because a quantity of FSR periods between the first reference optical signal and the second reference optical signal before adjustment is fixed, and a changed quantity of FSR periods during adjustment can be learned of, the quantity of FSR periods between the first optical signal and the second optical signal may be determined based on the changed quantity of FSR periods and the quantity of FSR periods between the first reference optical signal and the second reference optical signal before adjustment.

For example, a formula for calculating a quantity of FSR frequency periods between the first reference optical signal and the second reference optical signal is set as follows:

$$N = Nr \pm N1 \pm N2$$

In the formula, N represents the quantity of FSR frequency periods between the first optical signal and the second optical signal, Nr represents the quantity of FSR frequency periods between the first reference optical signal and the second reference optical signal, N1 represents the quantity of FSR frequency periods between the first optical signal and the first reference optical signal, and N2 represents the quantity of FSR frequency periods between the second optical signal and the second reference optical signal.

In this embodiment of this application, the first frequency control signal output by the control unit 3C may be used to adjust the frequency of the first optical signal output by the first laser A or the frequency of the first reference optical signal output by the first reference laser A3 may be adjusted, to adjust a value of N1. The second frequency control signal output by the control unit 3C may be used to adjust the frequency of the second reference optical signal output by the second reference laser B3, to adjust a value of N2. An objective of this application is to adjust the frequency of the first optical signal to maintain a specific frequency difference between the frequency of the first optical signal and the frequency of the second optical signal. Therefore, for precision of the frequency difference, the frequency of the second optical signal output by the second laser B is generally not adjusted.

S143: Adjust the frequency of the first optical signal.

In some possible embodiments, as shown in FIG. 6, FIG. 7, FIG. 8, FIG. 9, FIG. 10, FIG. 11, FIG. 12, FIG. 16, and FIG. 17, the control unit 3C outputs a frequency difference control signal to the first laser A based on the relative frequency difference between the first optical signal and the second optical signal, and controls, by using the frequency difference control signal, the first laser A to adjust the frequency of the first optical signal, so that the first optical signal and the second optical signal maintain a relative first frequency difference in one FSR frequency period.

For example, in a process of adjusting the frequency of the first optical signal, the frequency value of the first optical signal may also be aligned with a special frequency in one FSR frequency period, for example, a frequency D, a frequency E, or a frequency F shown in FIG. 25, so that frequency difference adjustment is more precise.

Optionally, in one FSR frequency period, there is a largest change in a slope of the frequency F in a frequency-power response relationship. Therefore, in an actual operation, the frequency F is aligned with the frequency of the second optical signal more easily.

In some possible implementations, as shown in FIG. 17, there are a plurality of first lasers A, and frequencies of the plurality of first lasers A need to be adjusted based on the frequency of the second optical signal. In this case, the selector 5C may be controlled to choose to output one of a plurality of first optical signals or output the second optical signal, so as to adjust frequency differences between the plurality of first optical signals and the second optical signal.

For example, the frequency difference adjustment method including step S110 to step S140 may be performed on each first optical signal based on the second optical signal.

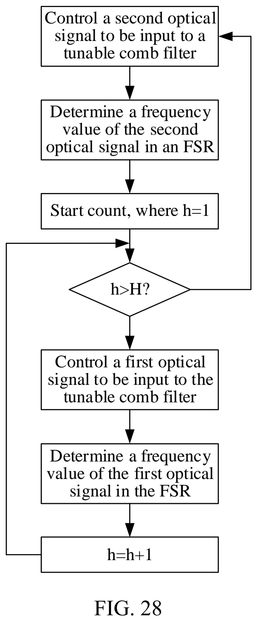

For example, the foregoing operations in step S110 and step S120 may be performed on each first optical signal, to determine the frequency value of the second optical signal. Then, the foregoing operations in step S130 and step S140 are sequentially performed on each first optical signal to determine a frequency value of a corresponding first optical signal and adjust a frequency difference. A specific procedure is shown in FIG. 28.

Optionally, a plurality of corresponding frequency differences between the plurality of first optical signals and the second optical signal may be completely the same, partially the same, or completely different.

In this embodiment of this application, the control unit 3C controls the selector 5C to output the first optical signal or the second optical signal. The first optical signal and the second optical signal are separately output, so that the tunable comb filter 1C and the first optical detection unit 2C can be reused. The control unit 3C determines the frequency difference between the first optical signal and the second optical signal based on the first filtered electrical signal and the second filtered electrical signal that are separately output by the first optical detection unit. In this embodiment of this application, the tunable comb filter 1C and the second optical detection unit 4C are reused. Both the first optical signal and the second optical signal are filtered and output by the tunable comb filter 1C. In this case, a quantity of frequency difference adjusters 10 is decreased, and there is no need to calibrate the frequency-power response relationship for the tunable comb filter 1C based on different temperatures.

In some possible implementations, the first optical signal and the second optical signal are simultaneously input to the tunable comb filter 1C. In this case, the following frequency difference adjustment method shown in FIG. 21 may be performed, including step S210 and step S220.

S210: Determine the frequency value of the first optical signal and the frequency value of the second optical signal.

In some possible implementations, the control unit 3C determines the frequency value of the second optical signal.

For example, as shown in FIG. 6, FIG. 7, FIG. 8, FIG. 9, FIG. 13, FIG. 14, FIG. 15, and FIG. 18, the control unit 3C may determine a relative position of the second optical signal in one FSR frequency period based on an optical power indicated by the second filtered electrical signal.

For example, as shown in FIG. 10, FIG. 13, and FIG. 14, the second optical signal is further input to the second optical detection unit 4C, and a second electrical signal is output. The control unit 3C determines the relative position of the second optical signal in one FSR frequency period based on a ratio between the second electrical signal and the second filtered electrical signal.

The structure shown in FIG. 13 is used as an example. The first splitter 6C is configured to input the first optical signal and the second optical signal, and output a mixed optical signal to the tunable comb filter 1C and the second demultiplexer 8C, where the mixed optical signal includes the first optical signal and the second optical signal. The tunable comb filter 1C is configured to output a mixed filtered optical signal to the first demultiplexer 7C based on the mixed optical signal, where the mixed filtered optical signal includes the first filtered optical signal and the second filtered optical signal. The first demultiplexer 7C is configured to output the first filtered optical signal to the first secondary photodetector 2C1, and output the second filtered optical signal to the first primary photodetector 2C2. The second demultiplexer 8C is configured to output the first optical signal to the second secondary photodetector 4C1, and output the second optical signal to the second primary photodetector 4C2. The first secondary photodetector 2C1 is configured to output the first filtered electrical signal to the control unit 3C based on the first filtered optical signal. The first primary photodetector 2C2 is configured to output the second filtered electrical signal to the control unit 3C based on the second filtered optical signal. The second secondary photodetector 4C1 is configured to output the first electrical signal to the control unit 3C based on the first optical signal. The second primary photodetector 4C2 is configured to output the second electrical signal to the control unit 3C based on the second optical signal.

In this embodiment of this application, the mixed optical signal including the first optical signal and the second optical signal is input to the tunable comb filter 1C, and the first demultiplexer 7C demultiplexes the first filtered optical signal and the second filtered optical signal. The first filtered optical signal is input to the first secondary photodetector 2C1, optical-to-electrical conversion is performed to obtain the first filtered electrical signal, and the first filtered electrical signal is output to the control unit 3C. The second filtered optical signal is input to the first primary photodetector 2C2, optical-to-electrical conversion is performed to obtain the second filtered electrical signal, and the second filtered electrical signal is output to the control unit 3C. After the mixed optical signal is input to the second demultiplexer 8C, the second demultiplexer 8C outputs the first optical signal to the second secondary photodetector 4C1, and outputs the second optical signal to the second primary photodetector 4C2. The second secondary photodetector 4C1 performs optical-to-electrical conversion on the first optical signal, and outputs the first electrical signal to the control unit 3C. The second primary photodetector 4C2 performs optical-to-electrical conversion on the second optical signal, and outputs the second electrical signal to the control unit 3C. The control unit 3C determines a ratio between the optical power of the first optical signal and the optical power of the first filtered optical signal based on the first electrical signal and the first filtered electrical signal, to determine a frequency value of the first optical signal in one FSR frequency period of the tunable comb filter 1C. The control unit 3C determines a ratio between the optical power of the second optical signal and the optical power of the second filtered optical signal based on the second electrical signal and the second filtered electrical signal, to determine a frequency value of the second optical signal in one FSR frequency period of the tunable comb filter 1C.

For example, as shown in FIG. 15 and FIG. 18, the control unit 3C determines the relative position of the second optical signal in one FSR frequency period based on an optical power ratio between the optical power indicated by the second filtered electrical signal and an optical power indicated by a second complementary filtered electrical signal.

FIG. 15 is used as an example. The tunable comb filter 1C is configured to output the first filtered optical signal to the first optical detection unit 2C based on the first optical signal, and output the second filtered optical signal to the first optical detection unit 2C based on the second optical signal; and output a first complementary filtered optical signal to the second optical detection unit 4C based on the first optical signal, and output a second complementary filtered optical signal to the second optical detection unit 4C based on the second optical signal. A frequency-power response relationship for the first filtered optical signal and a frequency-power response relationship for the first complementary filtered optical signal are reversed, and a frequency-power response relationship for the second filtered optical signal and a frequency-power response relationship for the second complementary filtered optical signal are reversed.

The first optical detection unit 2C is configured to output a first filtered electrical signal based on the first filtered optical signal, and output a second filtered electrical signal based on the second filtered optical signal, where the first filtered electrical signal indicates an optical power of the first filtered optical signal, and the second filtered electrical signal indicates an optical power of the second filtered optical signal. The second optical detection unit 4C is configured to output a first complementary filtered electrical signal based on the first complementary filtered optical signal, and output a second complementary filtered electrical signal based on the second complementary filtered optical signal, where the first complementary filtered electrical signal indicates an optical power of the first complementary filtered optical signal, and the second complementary filtered electrical signal indicates an optical power of the second complementary filtered optical signal.

The control unit 3C is specifically configured to output a frequency adjustment signal to the tunable comb filter 1C based on the second complementary filtered electrical signal and the second filtered electrical signal, where the frequency adjustment signal is used to adjust a frequency of the tunable comb filter 1C; output a first frequency control signal to the first laser A based on the first filtered electrical signal and the first complementary filtered electrical signal; output a second frequency control signal to a second laser B based on the second filtered electrical signal and the second complementary filtered electrical signal; and output the frequency difference control signal to the first laser A based on the first filtered electrical signal, the second filtered electrical signal, the first complementary filtered electrical signal, and the second complementary filtered electrical signal.

In this embodiment of this application, when the tunable comb filter 1C is a complementary tunable comb filter, for one optical signal, one filtered optical signal and one complementary filtered optical signal may be obtained, and frequency-power response relationships for the two optical signals are reversed. A change rate of an optical power difference between the filtered optical signal and the complementary filtered optical signal is greater than a change rate of an optical power difference between the filtered optical signal and the optical signal input to the tunable comb filter 1C. Therefore, compared with a non-complementary tunable comb filter, the complementary tunable comb filter can be used to more easily adjust a frequency value of the first optical signal and a frequency value of the second optical signal in one FSR frequency period of the tunable comb filter 1C.

For example, the control unit 3C may further adjust a frequency of the tunable comb filter 1C, so that the frequency value of the second optical signal is aligned with some frequencies in an FSR frequency period of the tunable comb filter 1C.

In some possible implementations, the control unit 3C determines the frequency value of the first optical signal.

For example, as shown in FIG. 6, FIG. 7, FIG. 8, FIG. 9, FIG. 13, FIG. 14, FIG. 15, and FIG. 18, the control unit 3C may determine a relative position of the first optical signal in one FSR frequency period based on an optical power indicated by the first filtered electrical signal.

For example, as shown in FIG. 10, FIG. 13, and FIG. 14, the first optical signal is further input to the second optical detection unit 4C, and a first electrical signal is output. The control unit 3C determines the relative position of the first optical signal in one FSR frequency period based on a ratio between the first electrical signal and the first filtered electrical signal.

For example, as shown in FIG. 15 and FIG. 18, the control unit 3C determines the relative position of the first optical signal in one FSR frequency period based on an optical power ratio between the optical power indicated by the first filtered electrical signal and an optical power indicated by a first complementary filtered electrical signal.

S220: Adjust a frequency difference between the first optical signal and the second optical signal to a first frequency difference.

For example, the frequency difference between the first optical signal and the second optical signal is adjusted to maintain the relative first frequency difference relative to one FSR frequency period.

For example, a formula for calculating the relative frequency difference between the first optical signal and the second optical signal is as follows:

$$\mathrm{dx} = \begin{cases} f1 - f2, Fs > Fm \\ f1 - f2, Fs < Fm \end{cases}$$

In the formula, dx represents the relative frequency difference between the first optical signal and the second optical signal, $f1$ represents a difference between a frequency value of the first optical signal in one FSR frequency period and a start frequency value of the FSR frequency period, $f2$ represents a difference between a frequency value of the second optical signal in one FSR frequency period and a start frequency value of the FSR frequency period, $Fs$ represents a frequency value of the first optical signal, and $Fm$ represents a frequency value of the second optical signal.

For example, the frequency difference between the first optical signal and the second optical signal is adjusted to the first frequency difference at an absolute frequency based on the quantity of FSR frequency periods between the first optical signal and the second optical signal.

For example, a formula for calculating the absolute frequency difference between the first optical signal and the second optical signal is as follows:

$$\mathrm{df} = \mathrm{Fs} - \mathrm{Fm} = \begin{cases} N * FSR - (f1 - f2), Fs > Fm \\ -N * FSR - (f1 - f2), Fs < Fm \end{cases}$$

In the formula, df represents the absolute frequency difference between the first optical signal and the second optical signal, $f1$ represents a difference between a frequency value of the first optical signal in one FSR frequency period and a start frequency value of the FSR frequency period, $f2$ represents a difference between a frequency value of the second optical signal in one FSR frequency period and a start frequency value of the FSR frequency period, *Fs* represents a frequency value of the first optical signal, *Fm* represents a frequency value of the second optical signal, and N represents the quantity of FSR frequency periods between the first optical signal and the second optical signal.

In some possible implementations, when the quantity of FSR frequency periods between the first optical signal and the second optical signal is unknown, the quantity N of FSR frequency periods between the first optical signal and the second optical signal may be determined by using the first reference optical signal and the second optical signal, where the first reference optical signal and the second reference optical signal are two optical signals that are determined based on the quantity of FSR frequency periods between the first optical signal and the second optical signal.

For example, the first reference laser A3, the second reference laser B3, the first period detector A2, and the second period detector B2 are further disposed in the frequency difference adjuster 10C. The first optical signal and the first reference optical signal are input to the first period detector A1, and the first period detector A1 outputs the first interval signal to the control unit 3C based on the first optical signal and the first reference optical signal, where the first interval signal indicates a quantity of interval FSR frequency periods between the first optical signal and the first reference optical signal. The control unit 3C outputs the first frequency control signal to the first laser A or the first reference laser A3 based on the first interval signal, so that a quantity of FSR periods between the first optical signal and the first reference optical signal is fixed by using the first frequency control signal, for example, the quantity of FSR periods between the first optical signal and the first reference optical signal is 0 (that is, the first optical signal and the first reference optical signal are in a same FSR period) or another fixed value. Similarly, the control unit 3C may obtain the second interval signal based on the second optical signal and the second reference optical signal, and output the second frequency control signal to the second laser B based on the second interval signal. The second frequency control signal is used to control the second laser B to adjust the frequency of the output second optical signal, so that a quantity of FSR frequency periods between the second optical signal and the second reference optical signal is fixed. For example, the quantity of FSR frequency periods between the second optical signal and the second reference optical signal is 0 or another fixed value. As shown in FIG. 27, because a quantity of FSR periods between the first reference optical signal and the second reference optical signal before adjustment is fixed, and a changed quantity of FSR periods during adjustment can be learned of, the quantity of FSR periods between the first optical signal and the second optical signal may be determined based on the changed quantity of FSR periods and the quantity of FSR periods between the first reference optical signal and the second reference optical signal before adjustment.

For example, a formula for calculating a quantity of FSR frequency periods between the first reference optical signal and the second reference optical signal is set as follows:

$$N = Nr \pm N1 \pm N2$$

In the formula, N represents the quantity of FSR frequency periods between the first optical signal and the second optical signal, Nr represents the quantity of FSR frequency periods between the first reference optical signal and the second reference optical signal, N1 represents the quantity of FSR frequency periods between the first optical signal and the first reference optical signal, and N2 represents the quantity of FSR frequency periods between the second optical signal and the second reference optical signal.

For a specific technical principle and technical effect of adjusting the frequency of the first optical signal to adjust the frequency difference between the first optical signal and the second optical signal, refer to the descriptions in the foregoing embodiments. Details are not described herein again.

Embodiments of this application provide a frequency difference adjuster, a frequency difference adjustment method, a laser generation apparatus, and an electronic device. In the frequency difference adjuster, one tunable comb filter is reused to filter the first optical signal and the second optical signal, to obtain the first filtered optical signal and the second filtered optical signal. Optical-to-electrical conversion is performed on the first filtered optical signal and the second filtered optical signal to obtain the first filtered electrical signal and the second filtered electrical signal. The frequency value of the first optical signal is obtained based on the first filtered electrical signal. The frequency value of the second optical signal is obtained based on the second filtered electrical signal. Then, the frequency difference control signal is used to control the first laser A to adjust the frequency of the output first optical signal, so that the frequency difference between the first optical signal and the second optical signal remains at the first frequency difference. Compared with a solution in which a polarization controller and a photodetector are used to implement frequency difference adjustment, in this embodiment of this application, the tunable comb filter is used, and a frequency difference range that can be detected and adjusted is larger. In addition, an FSR period of the comb filter is fixed and is hardly affected by a temperature. However, a start frequency of the comb filter is susceptible to the temperature. Therefore, in a scenario in which two comb filters are used, impact of the temperature on the two comb filters needs to be calibrated respectively, to obtain a frequency-power response relationship corresponding to an absolute frequency. However, in a scenario in which a tunable comb filter is reused, the frequency difference between the first optical signal and the second optical signal relative to the tunable comb filter remains stable, and there is no need to perform temperature calibration on a start frequency of the tunable comb filter, that is, there is no need to adjust the frequency difference between the first optical signal and the second optical signal.

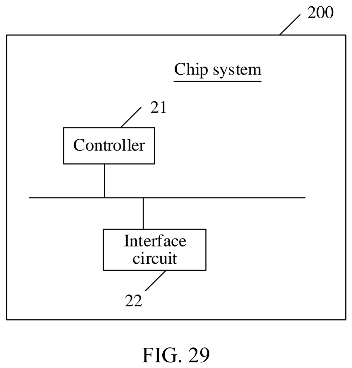

An embodiment of this application further provides a chip system. As shown in FIG. 29, the chip system 200 includes at least one controller 21 and at least one interface circuit 22. The at least one controller 21 and the at least one interface circuit 22 may be interconnected through a line. The controller 21 is configured to support the chip system 20 in implementing functions or steps in the foregoing method embodiments, for example, performing the methods shown in FIG. 19, FIG. 20, and FIG. 21. The at least one interface circuit 22 may be configured to receive a signal from another apparatus (for example, a laser or a memory), or send a signal to another apparatus (for example, a laser or a communication interface). The chip system 200 may include a chip, and may further include another discrete component.

An embodiment of this application further provides a computer-readable storage medium. The computer-readable storage medium includes instructions. When the instructions are run on the frequency difference adjuster including the structures shown in FIG. 6, FIG. 7, FIG. 8, FIG. 9, FIG. 10, FIG. 11, FIG. 12, FIG. 13, FIG. 14, FIG. 15, FIG. 16, FIG. 17, and FIG. 18, the frequency difference adjuster is enabled to perform the frequency difference adjustment method described in FIG. 19, FIG. 20, and FIG. 21. When the instructions are run on the laser generation apparatus including the structures shown in FIG. 6, FIG. 7, FIG. 8, FIG. 9, FIG. 10, FIG. 11, FIG. 12, FIG. 13, FIG. 14, FIG. 15, FIG. 16, FIG. 17, and FIG. 18, the laser generation apparatus is enabled to perform the frequency difference adjustment method described in FIG. 19, FIG. 20, and FIG. 21. When the instructions are run on the electronic device including the structures shown in FIG. 6, FIG. 7, FIG. 8, FIG. 9, FIG. 10, FIG. 11, FIG. 12, FIG. 13, FIG. 14, FIG. 15, FIG. 16, FIG. 17, and FIG. 18, the electronic device is enabled to perform the frequency difference adjustment method described in FIG. 19, FIG. 20, and FIG. 21. When the instructions are run on the chip system, the chip system is enabled to perform the frequency difference adjustment method described in FIG. 19, FIG. 20, and FIG. 21.

The processor in this embodiment of this application may be a chip. For example, the processor may be a field programmable gate array (field programmable gate array, FPGA), an application-specific integrated chip (application-specific integrated circuit, ASIC), a system on chip (system on chip, SoC), a central processing unit (central processing unit, CPU), a network processor (network processor, NP), a digital signal processing circuit (digital signal processor, DSP), a micro controller unit (micro controller unit, MCU), a programmable controller (programmable logic device, PLD), or another integrated chip.

The memory in embodiment of this application may be a volatile memory or a nonvolatile memory, or may include both a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. Through example but not limitative description, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchronous link dynamic random access memory (synchlink DRAM, SLDRAM), and a direct rambus dynamic random access memory (direct rambus RAM, DR RAM).

It should be noted that the memory of the systems and methods described in this specification includes but is not limited to these and any memory of another appropriate type.

It should be understood that sequence numbers of the foregoing processes do not mean execution sequences in various embodiments of this application. The execution sequences of the processes should be determined based on functions and internal logic of the processes, and should not be construed as any limitation on the implementation processes of embodiments of this application.

A person of ordinary skill in the art may be aware that, in combination with the examples described in embodiments disclosed in this specification, modules and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and module, refer to a corresponding process in the foregoing method embodiments, and details are not described herein again.

In the several embodiments provided in this application, it should be understood that, the disclosed system, device, and method may be implemented in other manners. For example, the described device embodiment is merely an example. For example, division into the modules is merely logical function division and may be other division in an actual implementation. For example, a plurality of modules or components may be combined or integrated into another device, or some features may be ignored or not performed. In addition, the displayed or discussed mutual couplings or direct couplings or communication connections may be implemented through some interfaces. The indirect couplings or communication connections between the devices or modules may be implemented in electronic, mechanical, or another form.

The modules described as separate parts may or may not be physically separate, and parts displayed as modules may or may not be physical modules, that is, may be located in one device, or may be distributed on a plurality of devices. Some or all the modules may be selected based on actual needs to achieve the objectives of the solutions of embodiments.

In addition, functional modules in embodiments of this application may be integrated into one device, or each of the modules may exist alone physically, or two or more modules are integrated into one device.

All or some of the foregoing embodiments may be implemented by software, hardware, firmware, or any combination thereof. When a software program is used to implement embodiments, all or some of the embodiments may be implemented in a form of a computer program product. The computer program product includes one or more computer instructions. When the computer program instructions are loaded and executed on a computer, all or some of the procedures or functions according to embodiments of this application are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (Digital Subscriber Line, DSL)) or wireless (for example, infrared, radio, or microwave) manner. The computer-readable storage medium may be any usable medium accessible by the computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid state drive (solid state drive, SSD)), or the like.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A frequency difference adjuster, comprising a tunable comb filter, a first optical detection unit, and a control unit, wherein the tunable comb filter is coupled to the first optical detection unit, and the first optical detection unit is coupled to the control unit, wherein

   the tunable comb filter is configured to output a first filtered optical signal to the first optical detection unit based on a first optical signal, and output a second filtered optical signal to the first optical detection unit based on a second optical signal, wherein the first optical signal is an optical signal output by a first laser;
   the first optical detection unit is configured to output a first filtered electrical signal based on the first filtered optical signal, and output a second filtered electrical signal based on the second filtered optical signal, wherein the first filtered electrical signal indicates an optical power of the first filtered optical signal, and the second filtered electrical signal indicates an optical power of the second filtered optical signal; and
   the control unit is configured to output a frequency difference control signal to the first laser based on the first filtered electrical signal and the second filtered electrical signal, wherein the frequency difference control signal is used to control the first laser to adjust a frequency difference between the first optical signal and the second optical signal to a first frequency difference.

2. The frequency difference adjuster according to claim 1, wherein the frequency difference adjuster further comprises a second optical detection unit, and the second optical detection unit is coupled to the control unit;

   the second optical detection unit is configured to output a first electrical signal based on the first optical signal, and output a second electrical signal based on the second optical signal, wherein the first electrical signal indicates an optical power of the first optical signal, and the second electrical signal indicates an optical power of the second optical signal; and
   the control unit is further configured to:
   output a frequency adjustment signal to the tunable comb filter based on the first electrical signal and the first filtered electrical signal, wherein the frequency adjustment signal is used to adjust a frequency of the tunable comb filter.

3. The frequency difference adjuster according to claim 2, wherein the frequency difference adjuster further comprises a selector and a first splitter, the selector is coupled to the first splitter and the control unit, and the first splitter is coupled to the tunable comb filter and the second optical detection unit;

the selector is configured to input the first optical signal and the second optical signal; and
the control unit is further configured to control the selector to output the first optical signal or the second optical signal to the tunable comb filter and the second optical detection unit through the first splitter.

4. The frequency difference adjuster according to claim 2, wherein the frequency difference adjuster further comprises a first splitter, a first demultiplexer, and a second demultiplexer, the first optical detection unit comprises a first primary photodetector and a first secondary photodetector, and the second optical detection unit comprises a second primary photodetector and a second secondary photodetector, wherein

an output end of the first splitter is coupled to an input end of the tunable comb filter and an input end of the second demultiplexer, and the first splitter is configured to input the first optical signal and the second optical signal;
an output end of the tunable comb filter is coupled to an input end of the first demultiplexer;
an output end of the first demultiplexer is coupled to an input end of the first primary photodetector and an input end of the first secondary photodetector;
an output end of the second demultiplexer is coupled to an input end of the second primary photodetector and an input end of the second secondary photodetector; and
an output end of the first primary photodetector, an output end of the first secondary photodetector, an output end of the second primary photodetector, and an output end of the second secondary photodetector are coupled to the control unit.

5. The frequency difference adjuster according to claim 2, wherein the frequency difference adjuster further comprises a combiner, a second splitter, a third splitter, and a first demultiplexer, the first optical detection unit comprises a first primary photodetector and a first secondary photodetector, and the second optical detection unit comprises a second primary photodetector and a second secondary photodetector, wherein

an output end of the second splitter is coupled to an input end of the combiner and an input end of the second primary photodetector, and the second splitter is configured to input the second optical signal;
an output end of the third splitter is coupled to the input end of the combiner and an input end of the second secondary photodetector, and the third splitter is configured to input the first optical signal;
an output end of the combiner is coupled to an input end of the tunable comb filter, and an output end of the tunable comb filter is coupled to an input end of the first demultiplexer;
an output end of the first demultiplexer is coupled to an input end of the first primary photodetector and an input end of the first secondary photodetector; and
an output end of the first primary photodetector, an output end of the first secondary photodetector, an output end of the second primary photodetector, and an output end of the second secondary photodetector are coupled to the control unit.

6. The frequency difference adjuster according to claim 1, wherein the tunable comb filter is a complementary tunable comb filter, the frequency difference adjuster further comprises a second optical detection unit, and the tunable comb filter is further coupled to the control unit through a second photodetector;

the tunable comb filter is further configured to output a first complementary filtered optical signal to the second optical detection unit based on the first optical signal, and output a second complementary filtered optical signal to the second optical detection unit based on the second optical signal, wherein a frequency-power response relationship for the first filtered optical signal and a frequency-power response relationship for the first complementary filtered optical signal are reversed, and a frequency-power response relationship for the second filtered optical signal and a frequency-power response relationship for the second complementary filtered optical signal are reversed;
the second optical detection unit is configured to output a first complementary filtered electrical signal based on the first complementary filtered optical signal, and output a second complementary filtered electrical signal based on the second complementary filtered optical signal, wherein the first complementary filtered electrical signal indicates an optical power of the first complementary filtered optical signal, and the second complementary filtered electrical signal indicates an optical power of the second complementary filtered optical signal; and
the control unit is specifically configured to:

output a frequency adjustment signal to the tunable comb filter based on the second complementary filtered electrical signal and the second filtered electrical signal, wherein the frequency adjustment signal is used to adjust a frequency of the tunable comb filter; and

output the frequency difference control signal to the first laser based on the first filtered electrical signal, the second filtered electrical signal, the first complementary filtered electrical signal, and the second complementary filtered electrical signal.

7. The frequency difference adjuster according to claim 6, wherein the frequency difference adjuster further comprises a selector, and the selector is coupled to the tunable comb filter;

the selector is configured to input the first optical signal and the second optical signal; and
the control unit is further configured to control the selector to output the first optical signal or the second optical signal to the tunable comb filter.

8. The frequency difference adjuster according to claim 6, wherein the frequency difference adjuster comprises a combiner, a first demultiplexer, and a second demultiplexer, the first optical detection unit comprises a first primary photodetector and a first secondary photodetector, and the second optical detection unit comprises a second primary photodetector and a second secondary photodetector, wherein

an output end of the combiner is coupled to an input end of the tunable comb filter, and the combiner is configured to input the first optical signal and the second optical signal;
an output end of the tunable comb filter is coupled to an input end of the first demultiplexer and an input end of the second demultiplexer;
an output end of the first demultiplexer is coupled to an input end of the first primary photodetector and an input end of the first secondary photodetector;
an output end of the second demultiplexer is coupled to an input end of the second primary photodetector and an input end of the second secondary photodetector; and
an output end of the first primary photodetector, an output end of the first secondary photodetector, an output end of the second primary photodetector, and an output end of the second secondary photodetector are coupled to the control unit.

9. The frequency difference adjuster according to any one of claims 1 to 8, wherein the second optical signal is an optical signal output by a second laser, and the frequency difference adjuster further comprises a first period detector, a second period detector, a first reference laser, and a second reference laser, wherein

the first reference laser is configured to output a first reference optical signal to the first period detector, and the second reference laser is configured to output a second reference optical signal to the second period detector, wherein a frequency period interval between the first reference optical signal and the second reference optical signal is fixed;
the first period detector is configured to output a first interval signal to the control unit based on the first optical signal and the first reference optical signal, wherein the first interval signal indicates a frequency period interval between the first optical signal and the first reference optical signal;
the second period detector is configured to output a second interval signal to the control unit based on the second optical signal and the second reference optical signal, wherein the second interval signal indicates a frequency period interval between the second optical signal and the second reference optical signal; and
the control unit is configured to:

output a first frequency control signal to the first laser based on the first interval signal, wherein the first frequency control signal is used to control the first laser to adjust a frequency of the first optical signal; or
output a first frequency control signal to the first reference laser based on the first interval signal, wherein the first frequency control signal is used to control the first reference laser to adjust a frequency of the first reference optical signal; and
output a second frequency control signal to the second laser based on the second interval signal, wherein the second frequency control signal is used to control the second laser to adjust a frequency of the second optical signal.

10. The frequency difference adjuster according to any one of claims 1 to 9, wherein the control unit comprises a signal processor and a controller, wherein

the signal processor is configured to output a frequency difference signal to the controller based on the first filtered electrical signal and the second filtered electrical signal, wherein the frequency difference signal indicates the frequency difference between the first optical signal and the second optical signal; and

the controller is configured to output the frequency difference control signal to the first laser based on the frequency difference signal.

11. A frequency difference adjustment method, applied to a frequency difference adjuster, wherein the frequency difference adjuster comprises a tunable comb filter, and the method comprises:

obtaining a first filtered optical signal based on a first optical signal, and obtaining a second filtered optical signal based on a second optical signal, wherein the first optical signal is an optical signal output by a first laser;

obtaining a first filtered electrical signal based on the first filtered optical signal, and obtaining a second filtered electrical signal based on the second filtered optical signal, wherein the first filtered electrical signal indicates an optical power of the first filtered optical signal, and the second filtered electrical signal indicates an optical power of the second filtered optical signal; and

outputting a frequency difference control signal to the first laser based on the first filtered electrical signal and the second filtered electrical signal, wherein the frequency difference control signal is used to control the first laser to adjust a frequency difference between the first optical signal and the second optical signal to a first frequency difference.

12. The method according to claim 11, wherein the method further comprises:

obtaining a first electrical signal based on the first optical signal, and obtaining a second electrical signal based on the second optical signal, wherein the first electrical signal indicates an optical power of the first optical signal, and the second electrical signal indicates an optical power of the second optical signal; and

outputting a frequency adjustment signal to the tunable comb filter based on the first electrical signal and the first filtered electrical signal, wherein the frequency adjustment signal is used to adjust a frequency of the tunable comb filter.

13. The method according to claim 12, wherein the method further comprises:
controlling the first optical signal or the second optical signal to be input to the tunable comb filter.

14. The method according to claim 11, wherein the tunable comb filter is a complementary tunable comb filter, and the method further comprises:

obtaining a first complementary filtered optical signal based on the first optical signal, and obtaining a second complementary filtered optical signal based on the second optical signal, wherein a frequency-power response relationship for the first filtered optical signal and a frequency-power response relationship for the first complementary filtered optical signal are reversed, and a frequency-power response relationship for the second filtered optical signal and a frequency-power response relationship for the second complementary filtered optical signal are reversed;

obtaining a first complementary filtered electrical signal based on the first complementary filtered optical signal, and obtaining a second complementary filtered electrical signal based on the second complementary filtered optical signal, wherein the first complementary filtered electrical signal indicates an optical power of the first complementary filtered optical signal, and the second complementary filtered electrical signal indicates an optical power of the second complementary filtered optical signal;

outputting a frequency adjustment signal to the tunable comb filter based on the second complementary filtered electrical signal and the second filtered electrical signal, wherein the frequency adjustment signal is used to adjust a frequency of the tunable comb filter; and

outputting the frequency difference control signal to the first laser based on the first filtered electrical signal, the second filtered electrical signal, the first complementary filtered electrical signal, and the second complementary filtered electrical signal.

15. The method according to claim 14, wherein the method further comprises:
controlling the first optical signal or the second optical signal to be input to the tunable comb filter.

16. The method according to any one of claims 11 to 15, wherein the second optical signal is an optical signal output by a second laser, and the method further comprises:

obtaining a first interval signal based on the first optical signal and a first reference optical signal, and obtaining a second interval signal based on the second optical signal and a second reference optical signal, wherein a frequency period interval between the first reference optical signal and the second reference optical signal is fixed, the first interval signal indicates a frequency period interval between the first optical signal and the first reference optical signal, and the second interval signal indicates a frequency period interval between the second optical signal and the second reference optical signal;

outputting a first frequency control signal to the first laser based on the first interval signal, wherein the first frequency control signal is used to control the first laser to adjust a frequency of the first optical signal; or outputting a first frequency control signal to a first reference laser based on the first interval signal, wherein the first frequency control signal is used to control the first reference laser to adjust a frequency of the first reference optical signal; and

outputting a second frequency control signal to the second laser based on the second interval signal, wherein the second frequency control signal is used to control the second laser to adjust a frequency of the second optical signal.

17. The method according to any one of claims 11 to 16, wherein outputting the frequency difference control signal to the first laser based on the first filtered electrical signal and the second filtered electrical signal comprises:

obtaining a frequency difference signal based on the first filtered electrical signal and the second filtered electrical signal, wherein the frequency difference signal indicates the frequency difference between the first optical signal and the second optical signal; and

outputting the frequency difference control signal to the first laser based on the frequency difference signal.

18. A laser generation apparatus, comprising a first laser and the frequency difference adjuster according to any one of claims 1 to 10.

19. An electronic device, comprising a circuit board and the laser generation apparatus according to claim 18.

20. A computer-readable storage medium, wherein the computer-readable storage medium comprises instructions; and when the instructions are run on the frequency difference adjuster according to any one of claims 1 to 10, the frequency difference adjuster is enabled to perform the method according to any one of claims 11 to 17; when the instructions are run on the laser generation apparatus according to claim 18, the laser generation apparatus is enabled to perform the method according to any one of claims 11 to 17; or when the instructions are run on the electronic device according to claim 19, the electronic device is enabled to perform the method according to any one of claims 11 to 17.

FIG. 1

FIG. 2

FIG. 3

```
Second          Second                              First
laser B    →    transmit            →           polarization
                splitter B1                     controller 1A

                    ↓                                   ↓
                                          ┌─────────────┐
First           First                 Optical        Optical-to-
laser A    →    transmit                coupler   →   electrical
                splitter A1                3A         converter 4A

                    ↓           Second          ↑
                            polarization    
                            controller 2A
```

Frequency difference adjuster 10A

Frequency
controller
6A

Difference
frequency
detector 5A

FIG. 4

FIG. 5

Second laser B → Second transmit splitter B1 → Splitter 1B → Wavelength etalon 2B → First photodetector 3B → First signal processor 5B → Frequency controller 5B

Second photodetector 4B → First signal processor 5B

Frequency difference adjuster 10B

First laser A → First transmit splitter A1 → Splitter 1B → Wavelength etalon 2B → First photodetector 3B → First signal processor 5B → Frequency controller 5B

Second photodetector 4B → First signal processor 5B

Frequency difference adjuster 10B

FIG. 6

FIG. 7

...

FIG. 8

FIG. 9

Second
optical signal

First optical
signal

→ Tunable
comb filter
1C

→ First optical
detection unit
2C

→ Control unit
3C

→ Second optical
detection unit
4C

Frequency
difference
adjuster 10C

FIG. 10

Second
laser B

→ Second
transmit
splitter B1

First laser
A

→ First
transmit
splitter A1

Selector
5C

→ Tunable
comb
filter 1C

→ First optical
detection
unit 2C

→ Control
unit 3C

Frequency difference
adjuster 10C

FIG. 11

FIG. 12

FIG. 13

FIG. 14

**FIG. 15**

**FIG. 16**

FIG. 17

FIG. 18

First secondary photodetector 2C1

First primary photodetector 2C2

Second secondary photodetector 4C1

Second primary photodetector 4C2

Control unit 3C

First demultiplexer 7C

Second demultiplexer 8C

Tunable comb filter 1C

Combiner 9C1

Frequency difference adjuster 10C

Second transmit splitter B1

First transmit splitter A1

Second laser B

First laser A

Control a second optical signal to be input to a tunable comb filter — S110

Determine a frequency value of the second optical signal in one FSR frequency period — S120

Control a first optical signal to be input to the tunable comb filter — S130

Adjust a frequency difference between the first optical signal and the second optical signal to a first frequency difference — S140

FIG. 19

Determine a frequency value of a first optical signal in one FSR frequency period — S141

Determine a frequency difference between the first optical signal and a second optical signal — S142

Adjust a frequency of the first optical signal — S143

FIG. 20

Determine a frequency value of a first optical signal and a frequency value of a second optical signal — S210

Adjust a frequency difference between the first optical signal and the second optical signal to a first frequency difference — S220

FIG. 21

FIG. 22

FIG. 23

FIG. 24

FIG. 25

FIG. 26

FIG. 27

FIG. 28

200

Chip system

21

Controller

Interface
circuit

22

FIG. 29

## INTERNATIONAL SEARCH REPORT

| International application No. |
| --- |
| **PCT/CN2024/070323** |

### A. CLASSIFICATION OF SUBJECT MATTER

H01S5/0687(2006.01)i

According to International Patent Classification (IPC) or to both national classification and IPC

### B. FIELDS SEARCHED

Minimum documentation searched (classification system followed by classification symbols)

IPC:H01S

Documentation searched other than minimum documentation to the extent that such documents are included in the fields searched

Electronic data base consulted during the international search (name of data base and, where practicable, search terms used)

CNKI, CNTXT, WPABSC, ENTXTC, VEN: 频率, 频差, 差频, 梳状, 滤波, 探测, 检测, 光电二极管, frequence, frequency, difference, comb, filter, detect, photodetector, PD.

### C. DOCUMENTS CONSIDERED TO BE RELEVANT

| Category* | Citation of document, with indication, where appropriate, of the relevant passages | Relevant to claim No. |
| --- | --- | --- |
| X | JP 2006245179 A (SUMITOMO OSAKA CEMENT CO., LTD.) 14 September 2006 (2006-09-14)<br>description, paragraphs [0025]-[0028], and figures 4-6 | 1-5, 10-13, 17-20 |
| A | CN 110165547 A (BEIJING CHANGCHENG INSTITUTE OF METROLOGY & MEASUREMENT, AVIC) 23 August 2019 (2019-08-23)<br>entire document | 1-20 |
| A | CN 114488082 A (SHANGHAI INSTITUTE OF OPTICS AND FINE MECHANICS, CHINESE ACADEMY OF SCIENCES) 13 May 2022 (2022-05-13)<br>entire document | 1-20 |
| A | JP 2022137910 A (TOKUSHIMA UNIVERSITY) 22 September 2022 (2022-09-22)<br>entire document | 1-20 |
| A | US 6163555 A (NORTEL NETWORKS LTD.) 19 December 2000 (2000-12-19)<br>entire document | 1-20 |
| A | US 6175389 B1 (CONEXANT SYSTEMS, INC.) 16 January 2001 (2001-01-16)<br>entire document | 1-20 |

☐ Further documents are listed in the continuation of Box C.  ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **08 March 2024** | **20 March 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/070323**

| Patent document cited in search report | | | Publication date (day/month/year) | Patent family member(s) | | | Publication date (day/month/year) |
|---|---|---|---|---|---|---|---|
| JP | 2006245179 | A | 14 September 2006 | JP | 4889951 | B2 | 07 March 2012 |
| CN | 110165547 | A | 23 August 2019 | None | | | |
| CN | 114488082 | A | 13 May 2022 | None | | | |
| JP | 2022137910 | A | 22 September 2022 | None | | | |
| US | 6163555 | A | 19 December 2000 | None | | | |
| US | 6175389 | B1 | 16 January 2001 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310176246